(19) Europäisches Patentamt
European Patent Office
Office européen des brevets

(11) EP 2 309 563 A1

(12) # EUROPEAN PATENT APPLICATION
published in accordance with Art. 153(4) EPC

(43) Date of publication:
**13.04.2011 Bulletin 2011/15**

(21) Application number: **09770136.1**

(22) Date of filing: **23.06.2009**

(51) Int Cl.:
***H01L 51/50*** *(2006.01)* ***C08G 61/12*** *(2006.01)*
***C08K 5/34*** *(2006.01)* ***C08K 5/56*** *(2006.01)*
***C08L 65/00*** *(2006.01)* ***C09K 11/06*** *(2006.01)*

(86) International application number:
**PCT/JP2009/061363**

(87) International publication number:
**WO 2009/157426 (30.12.2009 Gazette 2009/53)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **23.06.2008 JP 2008163040**

(71) Applicants:
- **Sumitomo Chemical Company, Limited**
**Tokyo 104-8260 (JP)**
- **Sumation Co., Ltd.**
**Chuo-ku**
**Tokyo 104-8260 (JP)**

(72) Inventor: **AKINO Nobuhiko**
**Tsukuba-shi**
**Ibaraki 305-0047 (JP)**

(74) Representative: **Duckworth, Timothy John**
**J.A. Kemp & Co.**
**14 South Square**
**Gray's Inn**
**London WC1R 5JJ (GB)**

(54) **COMPOSITION AND LIGHT-EMITTING ELEMENT USING THE COMPOSITION**

(57) Disclosed is a composition comprising a compound having a saturated heterocyclic structure, in which the number of ring-constituting members containing a nitrogen atom is 5 or more, and a phosphorescent compound.

EP 2 309 563 A1

## Description

TECHNICAL FIELD

The present invention relates to a composition and a light-emitting device prepared by using the composition.

BACKGROUND ART

As a light-emitting material for use in a light-emitting layer of a light-emitting device, a compound emitting light from a triplet excitation state (hereinafter, sometimes referred to as a "phosphorescent compound") is known. The device using this compound in a light-layer is known to have a high luminous efficiency. When a phosphorescent compound is used in a light-emitting layer, usually, a composition prepared by adding the compound to a matrix is used as a light-emitting material. As the matrix, polyvinylcarbazole is used since a thin film can be formed by coating (PATENT DOCUMENT 1).

However, it is difficult to inject electrons to this compound because the lowest unoccupied molecular orbital (hereinafter, referred to as the "LUMO") thereof is high. On the other hand, a conjugated polymer compound such as polyfluorene has a low LUMO. Thus, if it is used as a matrix, a low driving voltage can be realized relatively easily. However, it is considered that such a conjugated polymer compound, since the lowest triplet excitation energy (hereinafter, referred to as "$T_1$ energy") thereof is low, is not suitable as a matrix used for emitting light having a shorter wavelength than that of green light (Patent Document 2). For example, in a light-emitting material composed of polyfluorene as a conjugated polymer compound and a triplet emission compound (NON-PATENT DOCUMENT 1), light emission from triplet emission compound is weak. Thus, the luminous efficiency thereof is low.

CITATION LIST

PATENT DOCUMENTS

PATENT DOCUMENT 1: JP 2002-50483 A
PATENT DOCUMENT 2: JP 2002-241455 A

NON-PATENT DOCUMENT

NON-PATENT DOCUMENT 1: APPLIED PHYSICS LETTERS, 80, 13, 2308 (2002)

SUMMARY OF THE INVENTION

PROBLEMS TO BE SOLVED BY THE INVENTION

In the circumstances, an object of the present invention is to provide a light-emitting material capable of preparing a light-emitting device having an excellent luminous efficiency.

MEANS FOR SOLVING THE PROBLEMS

The present invention firstly provides a composition comprising: a compound having a saturated heterocyclic structure, the ring including a nitrogen atom and the constituent members of the ring being 5 or more; and a phosphorescent compound.

The present invention secondly provides a polymer compound having a residue of a compound represented by a formula selected from the group consisting of formulas (1-1), (1-2), (1-3), (2-1), (2-2), (2-3) and (2-4) described later and a residue of the phosphorescent compound.

The present invention thirdly provides a thin film and a light-emitting device prepared by using the composition or the polymer compound.

The present invention provides fourthly a planar light source, a display apparatus and a light having the light-emitting device.

ADVANTAGES OF THE INVENTION

The composition and polymer compound of the present invention (hereinafter, referred to as "the composition, etc. of the present invention") have a high luminous efficiency. Therefore, when they are used in preparing a light-emitting device, etc., a light-emitting device excellent in luminous efficiency can be obtained. Furthermore, the composition etc. of the present invention usually has a relatively excellent luminosity in green to blue light emission. This is because the polymer compound of the present invention, that is, a compound contained in the composition of the present invention and having a saturated heterocyclic structure, the ring including a nitrogen atom and the constituent members of the ring being 5 or more, has a large $T_1$ energy.

MODE FOR CARRYING OUT THE INVENTION

Next, the present invention will be more specifically described below. Note that in the specification, in the case where an alkyl group and an alkoxy group of a structural formula has no prefix (t-, etc.), they means n-.

<Composition>

The composition of the present invention is a composition containing: a compound having a saturated heterocyclic structure, the ring including a nitrogen atom and the constituent members of the ring being 5 or more; and a phosphorescent compound. In this specification, a "saturated heterocyclic structure" refers to a group provided by removing all or some (one or two in particular) of hydrogen atoms from a saturated heterocyclic compound. Furthermore, in the specification, a "polymer compound" refers to a compound having two or more identical structures (repeating units) in a single molecule.

- Compound having a saturated heterocyclic structure -

The compound having a saturated heterocyclic structure is a compound having a residue (more specifically, a group provided by removing all or some of hydrogen atoms from the compound) of a compound represented by, for example, a formula selected from the group consisting of the following formulas (1-1), (1-2), (1-3), (2-1), (2-2), (2-3) and (2-4):

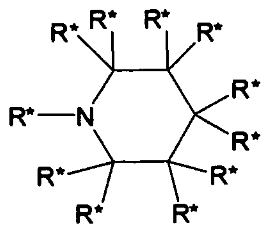
(1-1)

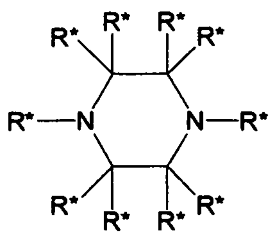
(1-2)

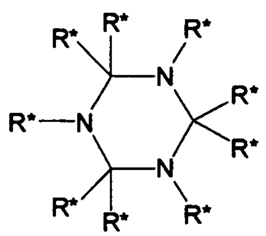
(1-3)

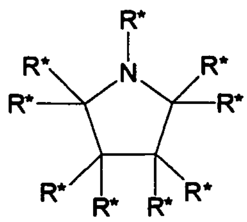
(2-1)

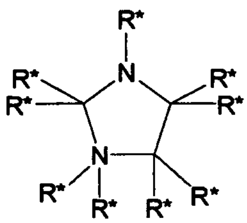
(2-2)

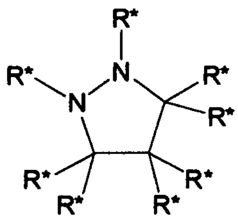
(2-3)

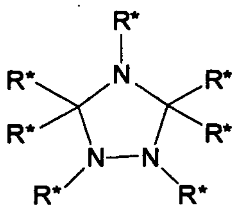
(2-4)

wherein $R^*$ represents a hydrogen atom or a substituent, or two $R^*$ bound to the same carbon atom integrally represent =O; and a plurality of $R^*$ may be the same or different; however, the compound preferably has at least two residues of these compounds.

When the compound having a saturated heterocyclic structure is a polymer compound, the polymer compound has a saturated heterocyclic structure in the main chain, a side chain or an end, or in a combination of these; however preferably in the main chain and/or a side chain.

When the compound having a saturated heterocyclic structure is a polymer compound, the polymer compound has a residue of a compound represented by a formula selected from the group consisting of the above formulas (1-1), (1-2), (1-3), (2-1), (2-2), (2-3) and (2-4) as a repeating unit, and more preferably has a residue of a compound represented by a formula selected from the group consisting of the above formulas (1-1), (1-2), (1-3), (2-1), (2-2), (2-3) and (2-4) and at least one structure selected from a structure having an aromatic ring, a structure having a hetero ring the number of constituent members of which including a hetero atom is 5 or more, an aromatic amine structure and a structure represented by a formula (4) described later, each as a repeating unit.

In the above formulas (1-1) to (2-4), examples of the substituent represented by $R^*$ include a halogen atom, an alkyl group, an alkoxy group, an alkylthio group, an aryl group that may have a substituent, an aryloxy group, an arylthio group, an arylalkyl group, an arylalkoxy group, an arylalkylthio group, an acyl group, an acyloxy group, an amide group, an acid imide group, an imine residue, a substituted amino group, a substituted silyl group, a substituted silyloxy group, a substituted silylthio group, a substituted silylamino group, a monovalent heterocyclic group that may have a substituent, a heteroaryl group that may have a substituent, a heteroaryloxy group, a heteroarylthio group, an arylalkenyl group, an arylethynyl group, a substituted carboxyl group and a cyano group, and preferably, include an alkyl group, an alkoxy group, an aryl group that may have a substituent and a heteroaryl group that may have a substituent. Note that the N-valent heterocyclic group (N is 1 or 2) refers to a remaining atomic group provided by removing N hydrogen atoms from a heterocyclic compound; the same applies hereinafter. Note that as a monovalent heterocyclic group, a monovalent aromatic heterocyclic group is preferable.

Examples of the halogen atom represented by the R* include a fluorine atom, a chlorine atom, a bromine atom and an iodine atom.

The alkyl group represented by the R* may be linear, branched or cyclic. The number of carbon atoms of the alkyl group is usually about 1 to 10. Examples of the alkyl group include a methyl group, an ethyl group, a propyl group, an isopropyl group, a butyl group, an isobutyl group, a s-butyl group, a t-butyl group, a pentyl group, a hexyl group, a cyclohexyl group, a heptyl group, an octyl group, a 2-ethylhexyl group, a nonyl group, a decyl group, a 3,7-dimethyloctyl group, a lauryl group, a trifluoromethyl group, a pentafluoroethyl group, a perfluorobutyl group, a perfluorohexyl group and a perfluorooctyl group, and preferably a t-butyl group, a pentyl group, a hexyl group, an octyl group, a 2-ethylhexyl group, a decyl group and a 3,7-dimethyloctyl group.

The alkoxy group represented by the R* may be linear, branched or cyclic. The number of carbon atoms of the alkoxy group is usually about 1 to 10. Examples of the alkoxy group include a methoxy group, an ethoxy group, a propyloxy group, an isopropyloxy group, a butoxy group, an isobutoxy group, a s-butoxy group, a t-butoxy group, a pentyloxy group, a hexyloxy group, a cyclohexyloxy group, a heptyloxy group, an octyloxy group, a 2-ethylhexyloxy group, a nonyloxy group, a decyloxy group, a 3,7-dimethyloctyloxy group, a lauryloxy group, a trifluoromethoxy group, a pentafluoroethoxy group, a perfluorobutoxy group, a perfluorohexyl group, a perfluorooctyl group, a methoxymethyloxy group and a 2-methoxyethyloxy group, and preferably a pentyloxy group, a hexyloxy group, an octyloxy group, a 2-ethylhexyloxy group, a decyloxy group and a 3,7-dimethyloctyloxy group.

The alkylthio group represented by the R* may be linear, branched or cyclic. The number of carbon atoms of the alkylthio group is usually about 1 to 10. Examples of the alkylthio group include a methylthio group, an ethylthio group, a propylthio group, an isopropylthio group, a butylthio group, an isobutylthio group, a s-butylthio group, a t-butylthio group, a pentylthio group, a hexylthio group, a cyclohexylthio group, a heptylthio group, an octylthio group, a 2-ethylhexylthio group, a nonylthio group, a decylthio group, a 3,7-dimethyloctylthio group, a laurylthio group and a trifluoromethylthio group, and preferably, a pentylthio group, a hexylthio group, an octylthio group, a 2-ethylhexylthio group, a decylthio group and a 3,7-dimethyloctylthio group.

The aryl group represented by the R* is an aryl group having usually about 6 to 60 carbon atoms, and preferably 7 to 48. Examples of the aryl group include a phenyl group, a $C_1$ to $C_{12}$ alkoxyphenyl group ("$C_1$ to $C_{12}$ alkoxy" means that the number of carbon atoms of the alkoxy moiety is 1 to 12. The same applies hereinafter), a $C_1$ to $C_{12}$ alkylphenyl group ("$C_1$ to $C_{12}$ alkyl" means that the number of carbon atoms of the alkyl moiety is 1 to 12. The same applies hereinafter)), a 1-naphthyl group, a 2-naphthyl group, a 1-anthracenyl group, a 2-anthracenyl group, a 9-anthracenyl group and a pentafluorophenyl group, and preferably a $C_1$ to $C_{12}$ alkoxyphenyl group and a $C_1$ to $C_{12}$ alkylphenyl group. The aryl group herein is the remaining atomic group provided by removing a single hydrogen atom from an aromatic hydrocarbon. Examples of the aromatic hydrocarbon include an aromatic hydrocarbon having a condensed ring, an aromatic hydrocarbon having at least two independent benzene rings or condensed rings directly bound or bound via e.g., a vinylene group. Furthermore, the aryl group may have a substituent. Examples of the substituent include a $C_1$ to $C_{12}$ alkoxyphenyl group and a $C_1$ to $C_{12}$ alkylphenyl group.

Examples of the $C_1$ to $C_{12}$ alkoxyphenyl group include a methoxyphenyl group, an ethoxyphenyl group, a propyloxyphenyl group, an isopropyloxyphenyl group, a butoxyphenyl group, an isobutoxyphenyl group, a s-butoxyphenyl group, a t-butoxyphenyl group, a pentyloxyphenyl group, a hexyloxyphenyl group, a cyclohexyloxyphenyl group, a heptyloxyphenyl group, an octyloxyphenyl group, a 2-ethylhexyloxyphenyl group, a nonyloxyphenyl group, a decyloxyphenyl group, a 3,7-dimethyloctyloxyphenyl group and a lauryloxyphenyl group.

Examples of the $C_1$ to $C_{12}$ alkylphenyl group include a methylphenyl group, an ethylphenyl group, a dimethylphenyl group, a propylphenyl group, a mesityl group, a methylethylphenyl group, an isopropylphenyl group, a butylphenyl group, an isobutylphenyl group, a s-butylphenyl, a t-butylphenyl group, pentylphenyl group, an isoamylphenyl group, a hexylphenyl group, a heptylphenyl group, an octylphenyl group, a nonylphenyl group, a decylphenyl group and a dodecylphenyl group.

The aryloxy group represented by the R* is an aryloxy group having usually about 6 to 60 carbon atoms, and preferably, 7 to 48. Examples of the aryloxy group include a phenoxy group, a $C_1$ to $C_{12}$ alkoxyphenoxy group, a $C_1$ to $C_{12}$ alkylphenoxy group, a 1-naphthyloxy group, a 2-naphthyloxy group and a pentafluorophenyloxy group, and preferably a $C_1$ to $C_{12}$ alkoxyphenoxy group and a $C_1$ to $C_{12}$ alkylphenoxy group.

Examples of the $C_1$ to $C_{12}$ alkoxyphenoxy group include a methoxyphenoxy group, an ethoxyphenoxy group, a propyloxyphenoxy group, an isopropyloxyphenoxy group, a butoxyphenoxy group, an isobutoxyphenoxy group, an s-butoxyphenoxy group, a t-butoxyphenoxy group, a pentyloxyphenoxy group, a hexyloxyphenoxy group, a cyclohexyloxyphenoxy group, a heptyloxyphenoxy group, an octyloxyphenoxy group, a 2-ethylhexyloxyphenoxy group, a nonyloxyphenoxy group, a decyloxyphenoxy group, a 3,7-dimethyl octyloxyphenoxy group and a lauryloxyphenoxy group.

Examples of the $C_1$ to $C_{12}$ alkylphenoxy group include a methylphenoxy group, an ethylphenoxy group, a dimethylphenoxy group, a propylphenoxy group, a 1,3,5-trimethylphenoxy group, a methylethylphenoxy group, an isopropylphenoxy group, a butylphenoxy group, an isobutylphenoxy group, a s-butylphenoxy group, a t-butylphenoxy group, a pentylphenoxy group, an isoamylphenoxy group, a hexylphenoxy group, a heptylphenoxy group, an octylphenoxy group, a nonylphenoxy

group, a decylphenoxy group and a dodecylphenoxy group.

The arylthio group represented by the R* is an arylthio group having usually about 6 to 60 carbon atoms, and preferably 7 to 48. Examples of the arylthio group include a phenylthio group, a $C_1$ to $C_{12}$ alkoxyphenylthio group, a $C_1$ to $C_{12}$ alkylphenylthio group, a 1-naphthylthio group, a 2-naphthylthio group and a pentafluorophenylthio group, and preferably a $C_1$ to $C_{12}$ alkoxyphenylthio group and a $C_1$ to $C_{12}$ alkylphenylthio group.

The arylalkyl group represented by the R* is an arylalkyl group having usually about 7 to 60 carbon atoms, and preferably 7 to 48. Examples of the arylalkyl group include a phenyl-$C_1$ to $C_{12}$ alkyl group, a $C_1$ to $C_{12}$ alkoxyphenyl-$C_1$ to $C_{12}$ alkyl group, a $C_1$ to $C_{12}$ alkylphenyl-$C_1$ to $C_{12}$ alkyl group, a 1-naphthyl-$C_1$ to $C_{12}$ alkyl group and a 2-naphthyl-$C_1$ to $C_{12}$ alkyl group, and preferably a $C_1$ to $C_{12}$ alkoxyphenyl-$C_1$ to $C_{12}$ alkyl group and a $C_1$ to $C_{12}$ alkylphenyl-$C_1$ to $C_{12}$ alkyl group.

The arylalkoxy group represented by the R* is arylalkoxy group having usually about 7 to 60 carbon atoms, and preferably 7 to 48. Examples of the arylalkoxy group include a phenyl-$C_1$ to $C_{12}$ alkoxy groups such as a phenylmethoxy group, a phenylethoxy group, a phenylbutoxy group, a phenylpentyloxy group, a phenylhexyloxy group, a phenylheptyloxy group and a phenyloctyoloxy group, a $C_1$ to $C_{12}$ alkoxy phenyl-$C_1$ to $C_{12}$ alkoxy group, a $C_1$ to $C_{12}$ alkylphenyl-$C_1$ to $C_{12}$ alkoxy group, a 1-naphthyl-$C_1$ to $C_{12}$ alkoxy group and a 2-naphthyl-$C_1$ to $C_{12}$ alkoxy group, and preferably a $C_1$ to $C_{12}$ alkoxyphenyl-$C_1$ to $C_{12}$ alkoxy group and a $C_1$ to $C_{12}$ alkylphenyl-$C_1$ to $C_{12}$ alkoxy group.

The arylalkylthio group represented by the R* is an arylalkylthio group having usually about 7 to 60 carbon atoms, and preferably 7 to 48. Examples of the arylalkylthio group include a phenyl-$C_1$ to $C_{12}$ alkylthio group, a $C_1$ to $C_{12}$ alkoxy phenyl-$C_1$ to $C_{12}$ alkylthio group, a $C_1$ to $C_{12}$ alkylphenyl-$C_1$ to $C_{12}$ alkylthio group, a 1-naphthyl-$C_1$ to $C_{12}$ alkylthio group and a 2-naphthyl-$C_1$ to $C_{12}$ alkylthio group, and preferably a $C_1$ to $C_{12}$ alkoxyphenyl-$C_1$ to $C_{12}$ alkylthio group and a $C_1$ to $C_{12}$ alkylphenyl-$C_1$ to $C_{12}$ alkylthio group.

The acyl group represented by the R* is an acyl group having usually about 2 to 20 carbon atoms, and preferably, 2 to 18. Examples of the acyl group include an acetyl group, a propionyl group, a butyryl group, an isobutyryl group, a pivaloyl group, a benzoyl group, a trifluoroacetyl group and a pentafluorobenzoyl group.

The acyloxy group represented by the R* is an acyloxy group having usually about 2 to 20 carbon atoms, and preferably, 2 to 18. Examples of the acyloxy group include an acetoxy group, a propionyloxy group, a butyryloxy group, an isobutyryloxy group, a pivaloyloxy group, a benzoyloxy group, a trifluoroacetyloxy group and a pentafluorobenzoyloxy group.

The amide group represented by the R* is an amide group having usually about 2 to 20 carbon atoms, and preferably, 2 to 18. Examples of the amide group include a formamide group, an acetamide group, a propioamide group, a butyroamide group, a benzamide group, a trifluoroacetamide group, a pentafluorobenzamide group, a diformamide group, a diacetamide group, a dipropioamide group, a dibutyroamide group, a dibenzamide group, a ditrifluoroacetamide group and a dipentafluorobenzamide group.

The acid imide group represented by the R* refers to a monovalent residue provided by removing a single hydrogen atom bound to the nitrogen atom from acid imide.

The acid imide group is an acid imide group having usually about 2 to 60 carbon atoms, and preferably 2 to 48. Examples of the acid imide group include groups represented by the following structural formulas.

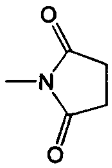
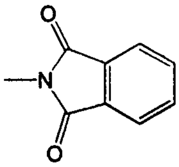
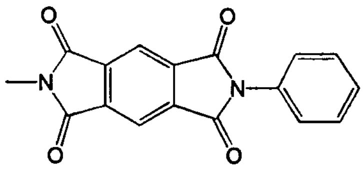
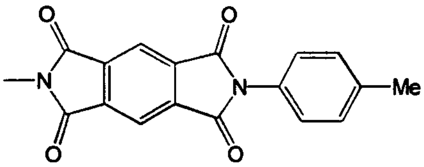
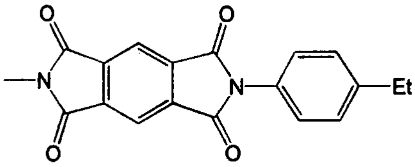
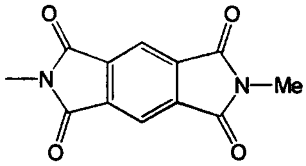
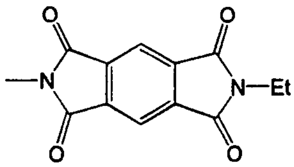
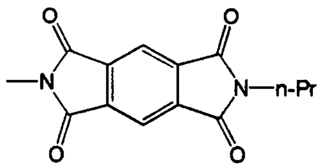
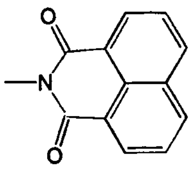
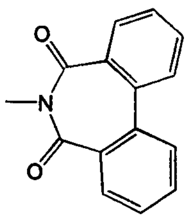

wherein the line extending from a nitrogen atom represents a bond; Me represents a methyl group, Et an ethyl group, and n-Pr an n-propyl group; the same applies hereinafter).

The imine residue represented by the R* refers to a monovalent residue provided by removing a single hydrogen atom from an imine compound (more specifically, an organic compound having -N=C- in the molecule, for example, aldimine, ketimine and compounds provided by replacing hydrogen atoms bound to nitrogen atoms in these molecules by an alkyl group, etc.). The imine residue is an imine residue having usually about 2 to 20 carbon atoms, and preferably 2 to 18 and specifically include groups represented by the following structural formulas.

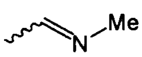
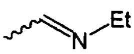
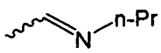
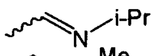
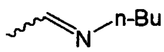
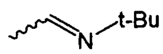
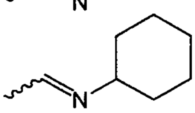
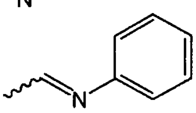
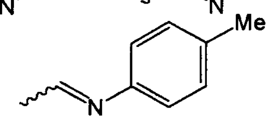
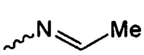
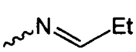
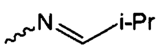
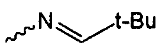
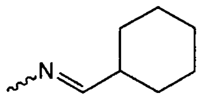
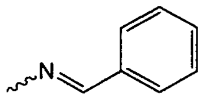
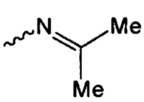
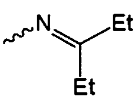
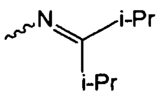
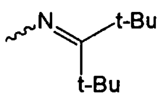
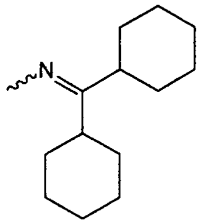
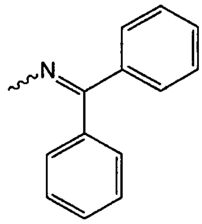
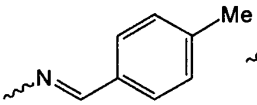
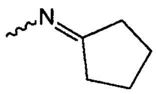
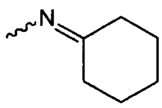

wherein i-Pr represents an isopropyl group, n-Bu a n-butyl group and t-Bu a t-butyl group; a bond indicated by a wavy line refers to a "bond represented by cuneiform" and/or "a bond represented by a broken line"; the "bond represented by cuneiform" means a bond protruding forward from the plane of paper, and a "bond represented by a broken line"

means a bond protruding backward from the plane of paper.

The substituted amino group represented by the $R^*$ refers to an amino group substituted by one or two groups selected from the group consisting of an alkyl group, an aryl group, an arylalkyl group and a monovalent heterocyclic group. The alkyl group, aryl group, arylalkyl group or monovalent heterocyclic group may have a substituent. The number of carbon atoms of the substituted amino group except the number of carbon atoms of the substituent is usually about 1 to 60, and preferably, 2 to 48. Examples of the substituted amino group include a methylamino group, a dimethylamino group, an ethylamino group, a diethylamino group, a propylamino group, a dipropylamino group, an isopropylamino group, a diisopropylamino group, a butylamino group, an isobutylamino group, a s-butylamino group, a t-butylamino group, a pentylamino group, a hexylamino group, a cyclohexylamino group, a heptylamino group, an octylamino group, a 2-ethylhexylamino group, a nonylamino group, a decylamino group, a 3,7-dimethyloctylamino group, a laurylamino group, a cyclopentylamino group, a dicyclopentylamino group, a cyclohexylamino group, a dicyclohexylamino group, a pyrrolidinyl group, a piperidyl group, a ditrifluoromethylamino group, a phenylamino group, a diphenylamino group, a $C_1$ to $C_{12}$ alkoxyphenylamino group, a di($C_1$ to $C_{12}$ alkoxyphenyl)amino group, a di($C_1$ to $C_{12}$ alkylphenyl)amino group, a 1-naphthylamino group, a 2-naphthylamino group, a pentafluorophenylamino group, a pyridylamino group, a pyridazinylamino group, a pyrimidylamino group, a pyrazylamino group, a triazylamino group, a phenyl-$C_1$ to $C_{12}$ alkylamino group, a $C_1$ to $C_{12}$ alkoxyphenyl-$C_1$ to $C_{12}$ alkylamino group, a $C_1$ to $C_{12}$ alkylphenyl-$C_1$ to $C_{12}$ alkylamino group, a di ($C_1$ to $C_{12}$ alkoxyphenyl-$C_1$ to $C_{12}$ alkyl)amino group, a di($C_1$ to $C_{12}$ alkylphenyl-$C_1$ to $C_{12}$ alkyl)amino group, a 1-naphthyl-$C_1$ to $C_{12}$ alkylamino group and a 2-naphthyl-$C_1$ to $C_{12}$ alkylamino group.

The substituted silyl group represented by the $R^*$ refers to a silyl group substituted by 1, 2 or 3 groups selected from the group consisting of an alkyl group, an aryl group, an arylalkyl group and a monovalent heterocyclic group. The number of carbon atoms of the substituted silyl group is usually about 1 to 60, and preferably 3 to 48. Note that the alkyl group, aryl group, arylalkyl group and monovalent heterocyclic group may have a substituent. Examples of the substituted silyl group include a trimethylsilyl group, a triethylsilyl group, a tripropylsilyl group, a triisopropylsilyl group, a dimethylisopropylsilyl group, a diethylisopropylsilyl group, a t-butyldimethylsilyl group, a pentyl dimethylsilyl group, a hexyldimethylsilyl group, a heptyldimethylsilyl group, an octyldimethylsilyl group, a 2-ethylhexyl-dimethylsilyl group, a nonyldimethylsilyl group, a decyldimethylsilyl group, a 3,7-dimethyloctyl-dimethylsilyl group, a lauryldimethylsilyl group, a phenyl-$C_1$ to $C_{12}$ alkylsilyl group, a $C_1$ to $C_{12}$ alkoxyphenyl-$C_1$ to $C_{12}$ alkylsilyl group, a $C_1$ to $C_{12}$ alkylphenyl-$C_1$ to $C_{12}$ alkylsilyl group, a 1-naphthyl-$C_1$ to $C_{12}$ alkylsilyl group, a 2-naphthyl-$C_1$ to $C_{12}$ alkylsilyl group, a phenyl-$C_1$ to $C_{12}$ alkyldimethylsilyl group, a triphenylsilyl group, a tri-p-xylylsilyl group, a tribenzylsilyl group, a diphenylmethylsilyl group, a t-butyldiphenylsilyl group and a dimethylphenylsilyl group.

The substituted silyloxy group represented by the $R^*$ refers to a silyloxy group substituted by 1, 2 or 3 groups selected from the group consisting of an alkoxy group, an aryloxy group, an arylalkoxy group and a monovalent heterocyclicoxy group. The number of carbon atoms of the substituted silyloxy group is usually about 1 to 60, and preferably 3 to 48. Note that the alkoxy group, aryloxy group, arylalkoxy group and monovalent heterocyclicoxy group may have a substituent. Examples of the substituted silyloxy group include a trimethylsilyloxy group, a triethylsilyloxy group, a tripropylsilyloxy group, a triisopropylsilyloxy group, a dimethylisopropylsilyloxy group, a diethylisopropylsilyloxy group, a t-butyldimethylsilyloxy group, a pentyldimethylsilyloxy group, a hexyldimethylsilyloxy group, a heptyldimethylsilyloxy group, an octyldimethylsilyloxy group, a 2-ethylhexyl-dimethylsilyloxy group, a nonyldimethylsilyloxy group, a decyldimethylsilyloxy group, a 3,7-dimethyloctyl-dimethylsilyloxy group, a lauryldimethylsilyloxy group, a phenyl-$C_1$ to $C_{12}$ alkylsilyloxy group, a $C_1$ to $C_{12}$ alkoxyphenyl-$C_1$ to $C_{12}$ alkylsilyloxy group, a $C_1$ to $C_{12}$ alkylphenyl-$C_1$ to $C_{12}$ alkylsilyloxy group, a 1-naphthyl-$C_1$ to $C_{12}$ alkylsilyloxy group, a 2-naphthyl-$C_1$ to $C_{12}$ alkylsilyloxy group, a phenyl $C_1$ to $C_{12}$ alkyldimethylsilyloxy group, a triphenylsilyloxy group, a tri-p-xylylsilyloxy group, a tribenzylsilyloxy group, a diphenylmethylsilyloxy group, a t-butyldiphenylsilyloxy group and a dimethylphenylsilyloxy group.

The substituted silylthio group represented by the $R^*$ refers to a silylthio group substituted by 1, 2 or 3 groups selected from the group consisting of an alkylthio group, an arylthio group, an arylalkylthio group and a monovalent heterocyclic thio group. The number of carbon atoms of the substituted silylthio group is usually about 1 to 60, and preferably 3 to 48. Note that the alkoxy group, arylthio group, arylalkylthio group and monovalent heterocyclicthio group may have a substituent. Examples of the substituted silylthio group include a trimethylsilylthio group, a triethylsilylthio group, a tripropylsilylthio group, a triisopropylsilylthio group, a dimethylisopropylsilylthio group, a diethylisopropylsilylthio group, a t-butyldimethylsilylthio group, a pentyldimethylsilylthio group, a hexyldimethylsilylthio group, a heptyldimethylsilylthio group, an octyldimethylsilylthio group, a 2-ethylhexyl-dimethylsilylthio group, a nonyldimethylsilylthio group, a decyldimethylsilylthio group, a 3,7-dimethyloctyl-dimethylsilylthio group, a lauryldimethylsilylthio group, a phenyl-$C_1$ to $C_{12}$ alkylsilylthio group, a $C_1$ to $C_{12}$ alkoxyphenyl-$C_1$ to $C_{12}$ alkylsilylthio group, a $C_1$ to $C_{12}$ alkylphenyl-$C_1$ to $C_{12}$ alkylsilylthio group, a 1-naphthyl-$C_1$ to $C_{12}$ alkylsilylthio group, a 2-naphthyl-$C_1$ to $C_{12}$ alkylsilylthio group, a phenyl-$C_1$ to $C_{12}$ alkyldimethylsilylthio group, a triphenylsilylthio group, a tri-p-xylylsilylthio group, a tribenzylsilylthio group, a diphenylmethylsilylthio group, a t-butyldiphenylsilylthio group and a dimethylphenylsilylthio group.

The substituted silylamino group represented by the $R^*$ refers to a silylamino group substituted by 1, 2 or 3 groups selected from the group consisting of an alkylamino group, an arylamino group, an arylalkylamino group and a

monovalent heterocyclic amino group. The number of carbon atoms of the substituted silylamino group is usually about 1 to 60, and preferably 3 to 48. The alkoxy group, arylamino group, arylalkylamino group and monovalent heterocyclic amino group may have a substituent. Examples of the substituted silylamino group include a trimethylsilylamino group, a triethylsilylamino group, a tripropylsilylamino group, a triisopropylsilylamino group, a dimethylisopropylsilylamino group, a diethylisopropylsilylamino group, a t-butyldimethylsilylamino group, a pentyldimethylsilylamino group, a hexyldimethylsilylamino group, a heptyldimethylsilylamino group, an octyldimethylsilylamino group, a 2-ethylhexyl-dimethylsilylamino group, a nonyldimethylsilyloamino group, a decyldimethylsilylamino group, a 3,7-dimethyloctyl-dimethylsilylamino group, a lauryldimethylsilylamino group, a phenyl-$C_1$ to $C_{12}$ alkylsilyloxy group, a $C_1$ to $C_{12}$ alkoxyphenyl-$C_1$ to $C_{12}$ alkylsilylamino group, a $C_1$ to $C_{12}$ alkylphenyl-$C_1$ to $C_{12}$ alkylsilylamino group, a 1-naphthyl-$C_1$ to $C_{12}$ alkylsilylamino group, a 2-naphthyl-$C_1$ to $C_{12}$ alkylsilylamino group, a phenyl-$C_1$ to $C_{12}$ alkyldimethylsilylamino group, a triphenylsilylamino group, a tri-p-xylylsilylamino group, a tribenzylsilylamino group, a diphenylmethylsilylamino group, a t-butyldiphenylsilyloamino group and a dimethylphenylsilylamino group.

The monovalent heterocyclic group represented by the R* refers to the remaining atomic group provided by removing a single hydrogen atom from a heterocyclic compound. The number of carbon atoms of the monovalent heterocyclic group is usually about 3 to 60, and preferably 3 to 20. Note that the number of carbon atoms of a substituent is not included in the number of carbon atoms of the monovalent heterocyclic group. The heterocyclic compound herein refers to an organic compound having a heterocyclic structure whose constituent elements within the ring are not only carbon atoms but also hetero atoms such as oxygen, sulfur, nitrogen, phosphorus and boron. Examples of the monovalent heterocyclic group include a thienyl group, a $C_1$ to $C_{12}$ alkylthienyl group, a pyrrolyl group, a furyl group, a pyridyl group, a $C_1$ to $C_{12}$ alkylpyridyl group, a piperidyl group, a quinolyl group, an isoquinolyl group, an oxazolyl group, a thiazolyl group, an imidazolyl group, a pyrazolyl group, an imidazolyl group, a pyrazolyl group, an oxadiazolyl group, a triazolyl group, a tetrazolyl group, a pyridyl group, a pyrimidyl group, a pyridazinyl group, a pyrazinyl group, a triazinyl group, an indolyl group, an indazolyl group, a benzimidazolyl group, a benzotriazolyl group, a carbazolyl group and a phenoxazinyl group. Furthermore, the monovalent heterocyclic group is preferably a monovalent aromatic heterocyclic group (heteroaryl group).

The heteroaryloxy group represented by the R* is a heteroaryloxy group having usually about 6 to 60 carbon atoms, and preferably, 7 to 48 carbon atoms. Examples of the heteroaryloxy group include a pyridyloxy group, a $C_1$ to $C_{12}$ alkoxypyridyloxy group, a $C_1$ to $C_{12}$ alkylpyridyloxy group and an isoquinolyloxy group, and preferably, a $C_1$ to $C_{12}$ alkoxypyridyloxy group, and a $C_1$ to $C_{12}$ alkylpyridyloxy group.

Examples of the $C_1$ to $C_{12}$ alkylpyridyloxy group include a methylpyridyloxy group, an ethylpyridyloxy group, a dimethylpyridyloxy group, a propylpyridyloxy group, a 1,3,5-trimethylpyridyloxy group, a methylethylpyridyloxy group, an isopropylpyridyloxy group, a butylpyridyloxy group, an isobutylpyridyloxy group, a s-butylpyridyloxy group, a t-butylpyridyloxy group, a pentylpyridyloxy group, an isoamylpyridyloxy group, a hexylpyridyloxy group, a heptylpyridyloxy group, an octylpyridyloxy group, a nonylpyridyloxy group, a decylpyridyloxy group and a dodecylpyridyloxy group.

The heteroarylthio group represented by the R* is a heteroarylthio group having usually about 6 to 60 carbon atoms, and preferably 7 to 48 carbon atoms. Examples of the heteroarylthio group include a pyridylthio group, a $C_1$ to $C_{12}$ alkoxypyridylthio group, a $C_1$ to $C_{12}$ alkylpyridylthio group and an isoquinolylthio group, and preferably a $C_1$ to $C_{12}$ alkoxypyridylthio group and a $C_1$ to $C_{12}$ alkylpyridylthio group.

The arylalkenyl group represented by the R* is an arylalkenyl group having usually about 8 to 60 carbon atoms and preferably, 8 to 48 carbon atoms. Examples of the arylalkenyl group include a phenyl-$C_2$ to $C_{12}$ alkenyl group ("$C_2$ to $C_{12}$ alkenyl" means that the number of carbon atoms of the alkenyl moiety is 2 to 12. The same applies hereinafter.), a $C_1$ to $C_{12}$ alkoxyphenyl-$C_2$ to $C_{12}$ alkenyl group, a $C_1$ to $C_{12}$ alkylphenyl-$C_2$ to $C_{12}$ alkenyl group, a 1-naphthyl-$C_2$ to $C_{12}$ alkenyl group and a 2-naphthyl-$C_2$ to $C_{12}$ alkenyl group and preferably a $C_1$ to $C_{12}$ alkoxyphenyl-$C_2$ to $C_{12}$ alkenyl group and a $C_2$ to $C_{12}$ alkylphenyl-$C_1$ to $C_{12}$ alkenyl group.

The arylalkynyl group represented by the R* is an arylalkynyl group having usually about 8 to 60 carbon atoms, and preferably 8 to 48 carbon atoms. Examples of the arylalkynyl group include a phenyl-$C_2$ to $C_{12}$ alkynyl group ("$C_2$ to $C_{12}$ alkynyl" means that the number of carbon atoms of the alkynyl moiety is 2 to 12. The same applies hereinafter.), a $C_1$ to $C_{12}$ alkoxyphenyl-$C_2$ to $C_{12}$ alkynyl group, a $C_1$ to $C_{12}$ alkylphenyl-$C_2$ to $C_{12}$ alkynyl group, a 1-naphthyl-$C_2$ to $C_{12}$ alkynyl group and a 2-naphthyl-$C_2$ to $C_{12}$ alkynyl group, and preferably a $C_1$ to $C_{12}$ alkoxyphenyl-$C_2$ to $C_{12}$ alkynyl group and a $C_1$ to $C_{12}$ alkylphenyl-$C_2$ to $C_{12}$ alkynyl group.

The substituted carboxyl group represented by the R* refers to a substituted carboxyl group having usually about 2 to 60 carbon atoms, and preferably 2 to 48 carbon atoms and substituted by an alkyl group, an aryl group, an arylalkyl group or a monovalent heterocyclic group. Examples of the substituted carboxyl group include a methoxycarbonyl group, an ethoxycarbonyl group, a propoxycarbonyl group, an isopropoxycarbonyl group, a butoxycarbonyl group, an isobutoxycarbonyl group, a s-butoxycarbonyl group, a t-butoxycarbonyl group, a pentyloxycarbonyl group, a hexyloxycarbonyl group, a cyclohexyloxycarbonyl group, a heptyloxycarbonyl group, an octyloxycarbonyl group, a 2-ethylhexyloxycarbonyl group, a nonyloxycarbonyl group, a decyloxycarbonyl group, a 3,7-dimethyloctyloxycarbonyl group, a dodecyloxycarbonyl group, a trifluoromethoxycarbonyl group, a pentafluoroethoxycarbonyl group, a perfluorobutoxycarbonyl group, a perfluorohexyloxycarbonyl group, a perfluorooctyloxycarbonyl group, a pyridyloxycarbonyl group, a naphthoxycarbonyl group and a pyridyloxycarbonyl group. The alkyl group, aryl group, arylalkyl group and monovalent heterocyclic group may have a substituent. The number of carbon atoms of the substituent is not included in the number of carbon atoms of a substituted carboxyl group.

As the compound having a saturated heterocyclic structure, a compound represented by, for example, the following formula (3):

$$ET^1 - \left( Y^1 \right)_{m_1} \left( HT \right)_n \left( Y^2 \right)_{m_2} ET^2 \qquad (3)$$

wherein HT represents a residue of a compound represented by the above formula (1-1), (1-2), (1-3), (2-1), (2-2), (2-3) or (2-4); n is an integer of 1 to 5; when n is 2 or more, a plurality ofHT may be the same or different; $Y^1$ and $Y^2$ each independently represent $-C(R^a)(R^b)-$, $-N(R^c)-$, $-O-$, $-Si(R^d)(R^e)-$, $-P(R^f)-$, $-S-$, $-C(=O)-$ or $-C(R^g)=C(R^h)-$. $R^a$, $R^b$, $R^c$, $R^d$, $R^e$, $R^f$, $R^g$ and $R^h$ each independently represent a hydrogen atom or a substituent; $m_1$ and $m_2$ are each independently an integer of 0 to 5; when $m_1$ is 2 or more, a plurality of $Y^1$ may be the same or different; when $m_2$ is 2 or more, a plurality of $Y^2$ may be the same or different; $ET^1$ and $ET^2$ each independently represent an aryl group that may have a substituent or a heteroaryl group that may have a substituent,
and a compound having a residue of the foregoing compound (more specifically, a group provided by removing all or some of hydrogen atoms of the compound).

In the above formula (3), n is preferably an integer of 1 to 3, more preferably 1 or 2, and particularly preferably, 1.

In the above formula (3), $m_1$ and $m_2$ preferably represent an integer of 0 to 3, and more preferably, 0 or 1.

Generally, the larger and more rigid a compound is, more excellent thermal stability is obtained. In the compound having a saturated heterocyclic structure contained in the composition of the present invention, a negative effect upon orientation and carrier transportation property, etc., can be suppressed by maintaining the rigidity of the compound so as not to reduce $T_1$ energy significantly.

In the above formula (3), examples of the aryl group that may have a substituent represented by $ET^1$ and $ET^2$ include a phenyl group, a $C_1$ to $C_{12}$ alkoxyphenyl group ("$C_1$ to $C_{12}$ alkoxy" means that the number of carbon atoms of the alkoxy moiety is 1 to 12. The same applies hereinafter.), a $C_1$ to $C_{12}$ alkylphenyl group ("$C_1$ to $C_{12}$ alkyl" means that the number of carbon atoms of the alkyl moiety is 1 to 12. The same applies hereinafter.), a 1-naphthyl group, a 2-naphthyl group and a pentafluorophenyl group, and preferably a phenyl group, a $C_1$ to $C_{12}$ alkoxyphenyl group and a $C_1$ to $C_{12}$ alkylphenyl group.

In the above formula (3), as the heteroaryl group that may have a substituent represented by $ET^1$ and $ET^2$, a heteroaryl group, etc. containing hetero atoms selected from the group consisting of an oxygen atom, a sulfur atom and a nitrogen atom other than carbon atoms, as atoms constituting the ring, may be mentioned. Examples thereof preferably include a thienyl group, a furyl group, a pyrrolyl group, an oxazolyl group, a thiazolyl group, an imidazolyl group, a pyrazolyl group, an imidazolyl group, a pyrazolyl group, an oxadiazolyl group, a triazolyl group, a tetrazolyl group, a pyridyl group, a pyrimidyl group, a pyridazinyl group, a pyrazinyl group, a triazinyl group, an indolyl group, an indazolyl group, a benzimidazolyl group, a benzotriazolyl group, a carbazolyl group and a phenoxazinyl group, and more preferably a pyridyl group, a pyrimidyl group, a pyridazinyl group, a pyrazinyl group, a triazinyl group, an indolyl group, an indazolyl group, a benzimidazolyl group, a benzotriazolyl group and a carbazolyl group.

In the above formula (3), in view of, solubility, energy level of the highest occupied molecular orbital (hereinafter, referred to as "HOMO") or the LUMO, at least one of $ET^1$ and $ET^2$ is preferably a heteroaryl group that may have a substituent, more preferably a heteroaryl group substituted by an alkyl group, an alkoxy group, an aryl group that may have a substituent or a heteroaryl group that may have a substituent, and particularly preferably a heteroaryl group substituted by an alkyl group having 3 to 10 carbon atoms, an alkoxy group having 3 to 10 carbon atoms, an aryl group substituted by an alkyl group having 3 to 10 carbon atoms or an alkoxy group having 3 to 10 carbon atoms, or an alkyl group having 3 to 10 carbon atoms or an alkoxy group having 3 to 10 carbon atoms.

In the above formula (3), substituents represented by $R^a$, $R^b$, $R^c$, $R^d$, $R^e$, $R^f$, $R^g$ and $R^h$, are the same as described and exemplified as the substituents represented by the $R^*$.

The compound having a saturated heterocyclic structure may contain another type of partial structure. A preferable another type of partial structure differs depending upon whether it is present at an end or not.

When another partial structure is present at an end, a stable substituent may be used, and in view of easiness of synthesis, a substituent represented by the $R^*$ or a hydrogen atom is preferable.

When another partial structure is present in the portion except an end, a stable polyvalent group having a conjugating property is preferable in view of LUMO and HOMO energy levels. Examples of such a group include a divalent aromatic group and a trivalent aromatic group. The aromatic group herein refers to a group derived from an

aromatic organic compound. Examples of such an aromatic group include groups provided by replacing n' (n' is 2 or 3) hydrogen atoms of an aromatic ring, such as benzene, naphthalene, anthracene, pyridine, quinoline and isoquinoline, by bonds.

As another partial structure that may be included in the compound having a saturated heterocyclic structure, a structure represented by the following formula (4) is preferable:

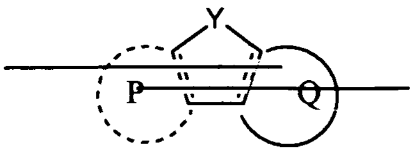

(4)

wherein ring P and ring Q each independently represent an aromatic ring; however, ring P may exist or not; when ring P is present, two bonds are present one on ring P and one on ring Q; when ring P is not present, two bonds are present one on a 5-membered ring or 6-membered ring including Y and one on ring Q; furthermore, on ring P, ring Q and a 5-membered ring or 6-membered ring including Y, a substituent may be present, which is selected from the group consisting of an alkyl group, an alkoxy group, an alkylthio group, an aryl group, an alkenyl group, an alkynyl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group and a cyano group; as the substituent, a substituent selected from the group consisting of an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group and a cyano group is preferable; Y represents -O-, -S-, -Se-, -B($R^0$)-, -Si($R^2$)($R^3$)-, -P($R^4$)-, -P($R^5$)(= O)-, -C($R^6$)($R^7$)-, - N($R^8$)-, -C($R^9$)($R^{10}$)-C($R^{11}$)($R^{12}$)-, -O-C($R^{13}$)($R^{14}$)-, -S-C($R^{15}$)($R^{16}$)-, -N-C($R^{17}$)($R^{18}$)-, - Si($R^{19}$)($R^{20}$)-C($R^{21}$)($R^{22}$)-, -Si($R^{23}$)($R^{24}$)-Si($R^{25}$)($R^{26}$)-, -C($R^{27}$) = C($R^{28}$)-, -N = C($R^{29}$)-, or - Si($R^{30}$) = C($R^{31}$)-; $R^0$ and $R^2$ to $R^{31}$ each independently represent a hydrogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a silyloxy group, a substituted silyloxy group, a monovalent heterocyclic group or a halogen atom.

In the above formula, as $R^0$ and $R^2$ to $R^{31}$, a hydrogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkenyl group, an amino group, a substituted amino group, a silyl group, a substituted silyl group, a silyloxy group, a substituted silyloxy group, a monovalent heterocyclic group and a halogen atom are preferable; an alkyl group, an alkoxy group, an alkylthio group, an aryl group, an aryloxy group, an arylthio group, an arylalkyl group, an arylalkoxy group and a monovalent heterocyclic group are more preferable; an alkyl group, an alkoxy group, an aryl group and a monovalent heterocyclic group are further preferable; and an alkyl group and an aryl group are particularly preferable.

Examples of the structure represented by the above formula (4) include a structure represented by the following formula (4-1), (4-2) or (4-3):

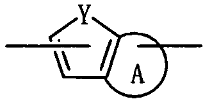

(4-1)

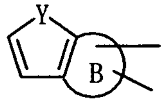

(4-2)

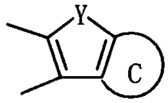

(4-3)

wherein ring A, ring B and ring C each independently represent an aromatic ring; formulas (4-1), (4-2) and (4-3) each may have a substituent selected from the group consisting of an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group and a cyano group; and Y is as defined above,

and a structure represented by the following formula (4-4) or (4-5):

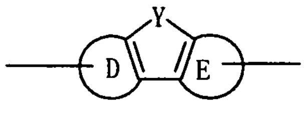

(4-4)

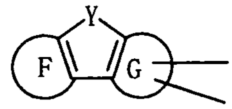

(4-5)

wherein ring D, ring E, ring F and ring G each independently represent an aromatic ring that may have a substituent selected from the group consisting of an alkyl group, an alkoxy group, an alkylthio group, an aryl group, an aryloxy group, an arylthio group, an arylalkyl group, an arylalkoxy group, an arylalkylthio group, an arylalkenyl group an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group and a cyano group; and Y is as defined above.

In the above formulas (4-4) and (4-5), Y is preferably a carbon atom, a nitrogen atom, an oxygen atom or a sulfur atom in view of luminous efficiency.

In the formulas (4-1) to (4-5), examples of aromatic rings represented by ring A to ring G and having no substituents include aromatic hydrocarbon rings such as a benzene ring, a naphthalene ring, an anthracene ring, a tetracene ring, a pentacene ring, a pyrene ring and a phenanthrene ring; and heteroaromatic rings such as a pyridine ring, a bipyridine ring, a phenanthroline ring, a quinoline ring, an isoquinoline ring, a thiophene ring, a furan ring and a pyrrole ring. These aromatic rings may have substituents.

As another partial structure that may be contained in the compound having a saturated heterocyclic structure, an aromatic amine structure represented by the following formula may be mentioned.

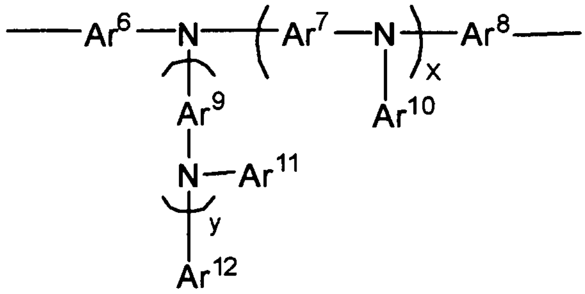

wherein $Ar^6$, $Ar^7$, $Ar^8$ and $Ar^9$ each independently represent an arylene group or a divalent heterocyclic group; $Ar^{10}$, $Ar^{11}$ and $Ar^{12}$ each independently represent an aryl group or a monovalent heterocyclic group; $Ar_6$ to $Ar_{12}$ may have a substituent; and x and y each independently represent 0 or 1 and satisfy $0 \leq x + y \leq 1$.

The arylene group represented by each of $Ar^6$, $Ar^7$, $Ar^8$ and $Ar^9$ is the remaining atomic group provided by removing two hydrogen atoms from an aromatic hydrocarbon. Examples of the aromatic hydrocarbon include a compound having a condensed ring and a compound having at least two independent benzene rings or condensed rings directly bonded or bonded via e.g., a vinylene group.

A divalent heterocyclic group represented by each of $Ar^6$, $Ar^7$, $Ar^8$ and $Ar^9$ is the remaining atomic group provided by removing two hydrogen atoms from a heterocyclic compound. The number of carbon atoms of the divalent heterocyclic group is usually around 4 to 60. The heterocyclic compound refers to an organic compound having a cyclic structure and containing not only carbon atoms but also hetero atoms such as oxygen, sulfur, nitrogen, phosphorus, boron as elements constituting the ring. As the divalent heterocyclic group, a divalent aromatic heterocyclic group is preferable.

An aryl group represented by each of $Ar^{10}$, $Ar^{11}$ and $Ar^{12}$ is the remaining atomic group provided by removing a single hydrogen atom from an aromatic hydrocarbon. The aromatic hydrocarbon is as defined above.

A monovalent heterocyclic group represented by each $Ar^{10}$, $Ar^{11}$ and $Ar^{12}$ refers to as the remaining atomic group provided by removing a single hydrogen atom from a heterocyclic compound. The number of carbon atoms of the monovalent heterocyclic group is usually around 4 to 60. The heterocyclic compound is as defined above. As the monovalent heterocyclic group, a monovalent aromatic heterocyclic group is preferable.

When the compound having a saturated heterocyclic structure, the polystyrene equivalent weight average

molecular weight of the compound is preferably $3 \times 10^2$ or more in view of film formation property, more preferably, $3 \times 10^2$ to $1 \times 10^7$, further preferably, $1 \times 10^3$ to $1 \times 10^7$, and particularly preferably, $1 \times 10^4$ to $1 \times 10^7$.

The compound having a saturated heterocyclic structure can be used in a wide emission wavelength region. For this, preferably, the $T_1$ energy value of the compound is preferably 3.0 eV or more, more preferably 3.2 eV or more, further preferably 3.4 eV or more, and particularly preferably, 3.6 eV or more. Furthermore, the upper limit is usually 5.0 eV

The absolute value of the HOMO energy level of the compound having a saturated heterocyclic structure is preferably 6.0 eV or less, more preferably, 5.8 eV or less, and further preferably 5.6 eV or less. Furthermore, the lower limit is usually 5.0 eV

The absolute value of the LUMO energy level of the compound having a saturated heterocyclic structure is preferably 1.5 eV or more, more preferably, 1.7 eV or more, further preferably 1.9 eV or more, and particularly preferably 2.1 eV or more. Furthermore, the upper limit is usually 4.0 eV

In the specification, for a $T_1$ energy value of each compound, a value of an LUMO energy level and a value of an HOMO energy level, the values calculated by a computational scientific approach are used. In the specification, as the computational scientific approach, optimization of a ground state structure was performed by the Hartree-Fock (HF) method using a quantum chemical calculation program, Gaussian03, and then, in the optimized structure, a $T_1$ energy value and a value of an LUMO energy level are obtained by using a B3P86 level time-dependent density functional method. At this time, as a basis function, 6-31g* is used. When the basis function 6-31g* cannot be used, LANL2DZ is used.

In the case where the compound having a saturated heterocyclic structure is a polymer compound and the polymer compound is constituted of single-type repeating units, assuming that the repeating unit is represented by A, the compound having a saturated heterocyclic structure is expressed by the following formula:

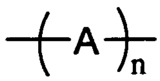

wherein n represents the number of polymerization units. Herein, a $T_1$ energy value, a value of an LUMO energy level and a value of an HOMO energy level are calculated in the cases of structures given by n = 1, 2 and 3. The $T_1$ energy value, the value of an LUMO energy level and the value of an HOMO energy level calculated are linearly approximated as a function of (1/n). The values of n = ∞ of this case are defined as the $T_1$ energy value, the value of the LUMO energy level and the value of the HOMO energy level of the polymer.

In the case where the compound having a saturated heterocyclic structure is a polymer compound and the number of types of repeating units constituting the polymer compound is 2 or more, a $T_1$ energy value at n = ∞ (n herein is the number of polymerization units of a repeating unit) is calculated in the same manner as above with respect to all cases of satisfying a composition ratio. Of them, the lowest $T_1$ energy value is defined as the $T_1$ energy value of the compound. The value of the LUMO energy level and the value of the HOMO energy level of the polymer compound are defined as values at n = ∞ in the repeating unit providing the lowest $T_1$ energy value. In the present invention, the absolute values of the "value of an LUMO energy level" and the "value of an HOMO energy level" (more specifically, in the case where the values of LUMO and HOMO energy level are expressed by negative values, the absolute values refer to the values provided by eliminating the negative symbol from the negative values) are important.

The compound having a saturated heterocyclic structure contains a residue of a compound represented by the above formula (3), at least one of the groups represented by $ET^1$ and $ET^2$ (preferably, groups represented by $ET^1$ and $ET^2$) is preferably bound to a partial structure having at least two π-conjugated electrons. Furthermore, the groups represented by $ET^1$ and $ET^2$ are bound to a partial structure having at least two π-conjugated electrons and the dihedral angles between the groups represented by $ET^1$ and $ET^2$ and the partial structure are preferably 20° or more, more preferably 30° or more, further preferably 50° or more, particularly preferably 65° or more and especially preferably 75° or more.

Furthermore, in the compound having a saturated heterocyclic structure, in the case where unsaturated rings such as an aromatic ring and a heteroaromatic ring are mutually bound, the dihedral angles of all unsaturated rings are preferably 30° or more, more preferably 50° or more, further preferably 65° or more, and particularly preferably 75° or more.

Here, in the specification, the "dihedral angle" refers to an angle calculated from the optimized structure in a ground state. The dihedral angle is defined, for example, in the above formula(3), by a carbon atom ($a_1$) which is located at a bonding position and the carbon atom or nitrogen atom ($a_2$) located next to $a_1$ in the group represented by $ET_1$ or $ET_2$, and an atom ($a_3$) located in the bonding position and an atom ($a_4$) located next to $a_3$ in a structure bonding to the group represented by $ET_1$ or $ET_2$. If a plurality of atoms ($a_2$) or atoms ($a_4$) can be selected herein, dihedral angles of all cases are calculated. Of them, the lowest value (180° or less) is employed as the dihedral angle. The atoms ($a_3$) and ($a_4$) are atoms having π-conjugated electrons, and more preferably, are carbon atoms, nitrogen atoms, silicon atoms and phosphorus atoms. In the specification, calculation is made from an optimized structure (more specifically, the

structure produced with the lowest production energy) at n = 3 (n is the number of polymerization units) in a ground state obtained by a computational scientific approach. In the compound having a saturated heterocyclic structure, when there are a plurality of dihedral angles, all dihedral angles of the compound preferably satisfy the above conditions.

As the compound having a saturated heterocyclic structure, compounds represented by the following formulas (5-1) to (5-30) are mentioned. In the formulas (5-1) to (5-30), R represents a hydrogen atom or a substituent. Examples of the substituent represented by R include a halogen atom, an alkyl group, an alkoxy group, an alkylthio group, an aryl group that may have a substituent, an aryloxy group, an arylthio group, an arylalkyl group, an arylalkyloxy group, an arylalkylthio group, an acyl group, an acyloxy group, an amide group, an acid imide group, an imide residue, a substituted amino group, a substituted silyl group, a substituted silyloxy group, a substituted silylthio group, a substituted silylamino group, a monovalent heterocyclic group that may have a substituent, an heteroaryl group that may have a substituent, a heteroaryloxy group, a heteroarylthio group, an arylalkenyl group, an arylethynyl group, a substituted carboxyl group and a cyano group. As R, an alkyl group, an alkoxy group, an aryl group that may have a substituent and a heteroaryl group that may have a substituent are preferable. A plurality of R and $R^*$ may be independently the same or different. $R^*$ is as defined above.

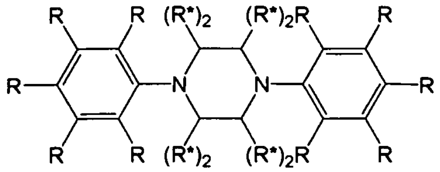
(5-1)

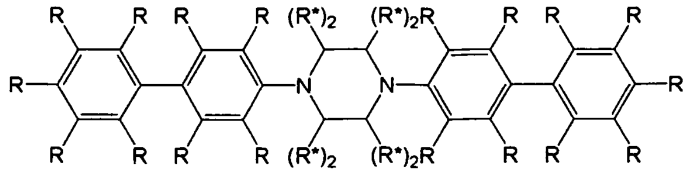
(5-2)

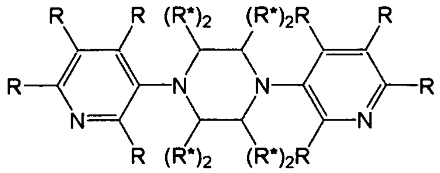
(5-3)

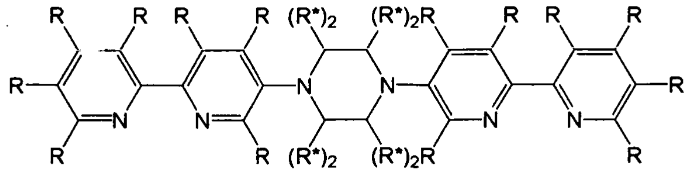
(5-4)

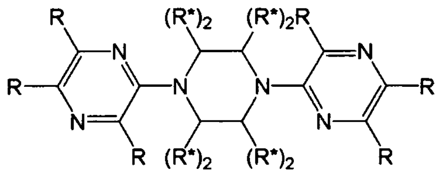
(5-5)

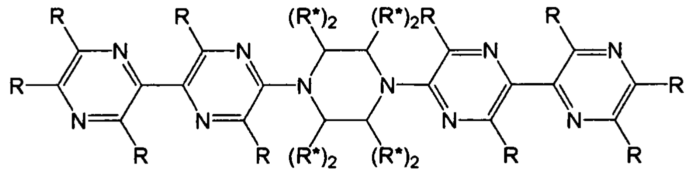
(5-6)

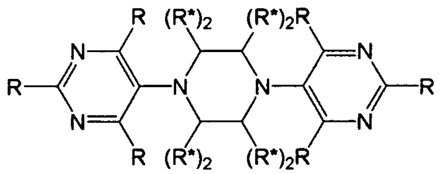
(5-7)

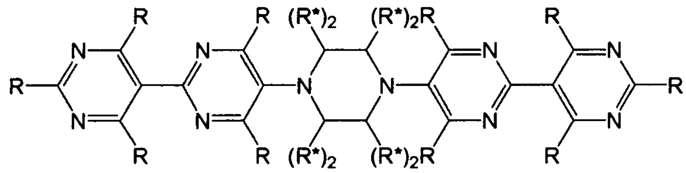
(5-8)

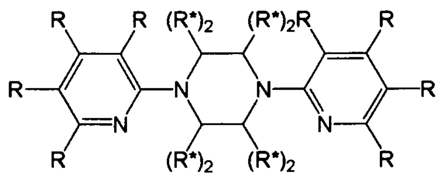
(5-9)

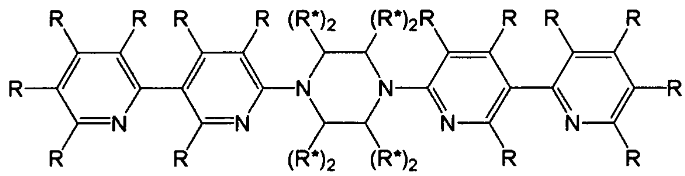
(5-10)

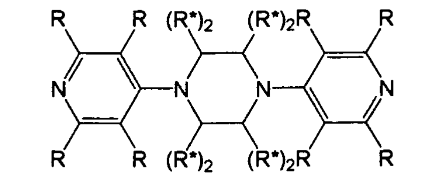
(5-11)

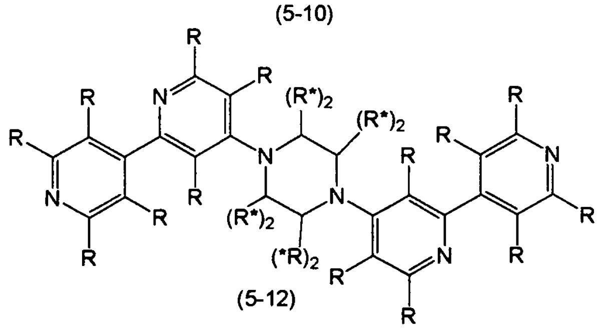
(5-12)

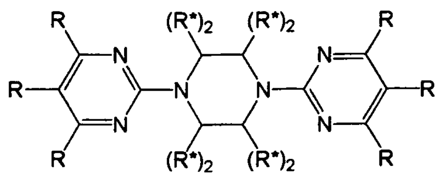
(5-13)

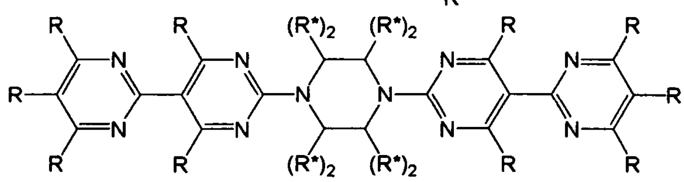
(5-14)

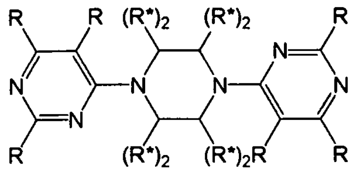

(5-15)

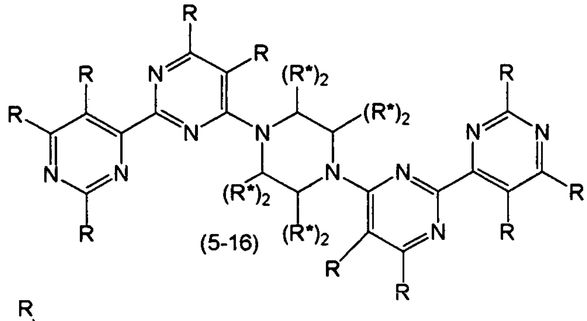

(5-16)

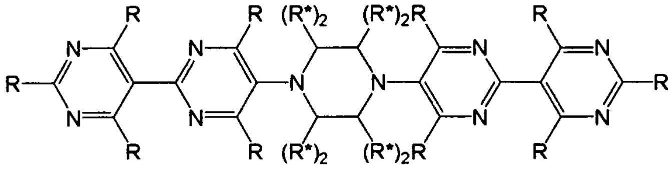

(5-17)

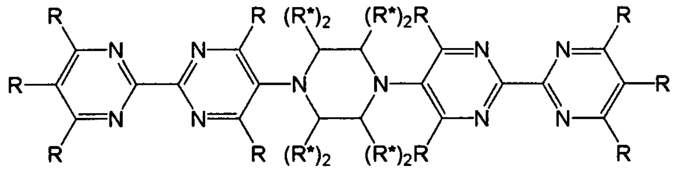

(5-18)

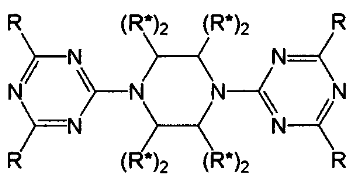

(5-19)

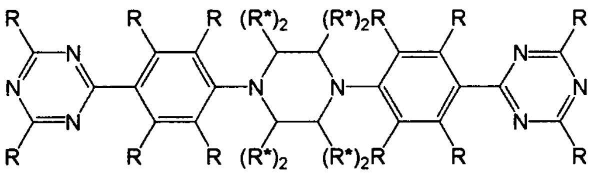

(5-20)

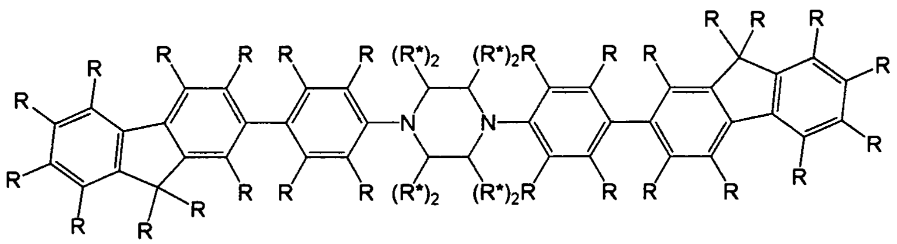

(5-21)

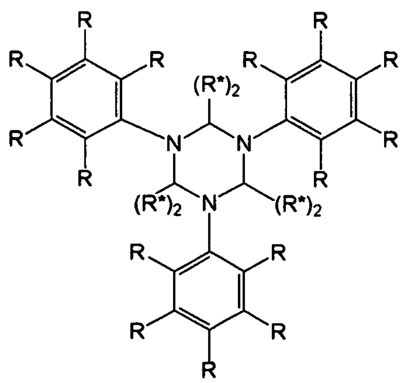

(5-22)

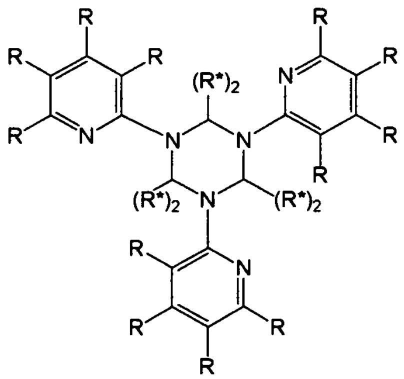

(5-23)

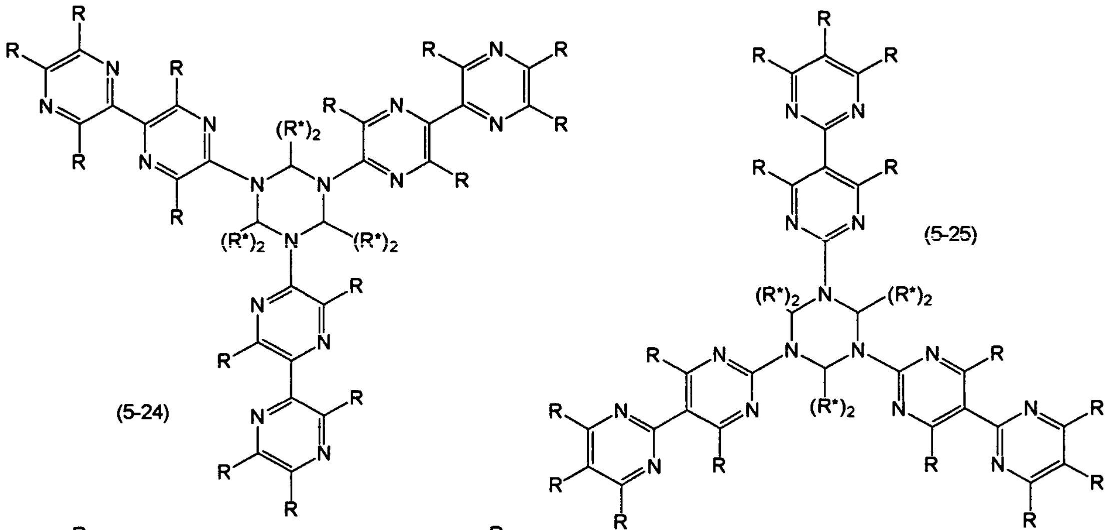

(5-24)

(5-25)

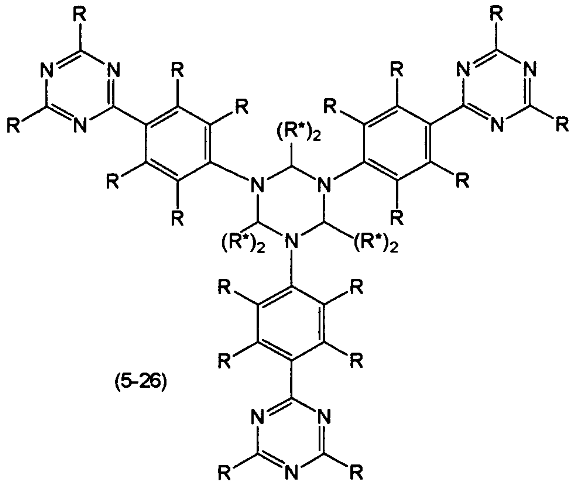

(5-26)

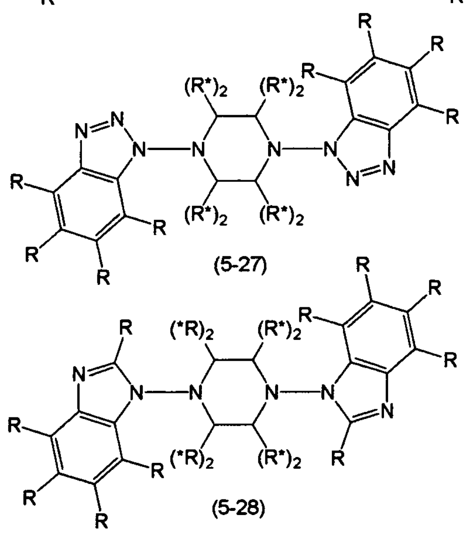

(5-27)

(5-28)

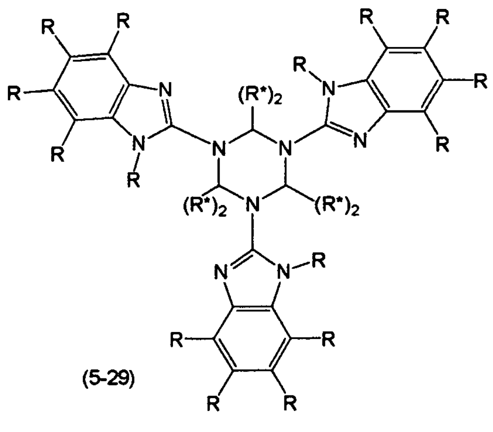

(5-29)

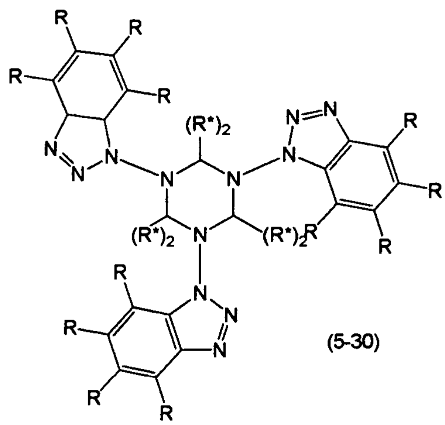

(5-30)

As the compound having a saturated heterocyclic structure, the following compounds may also be mentioned.

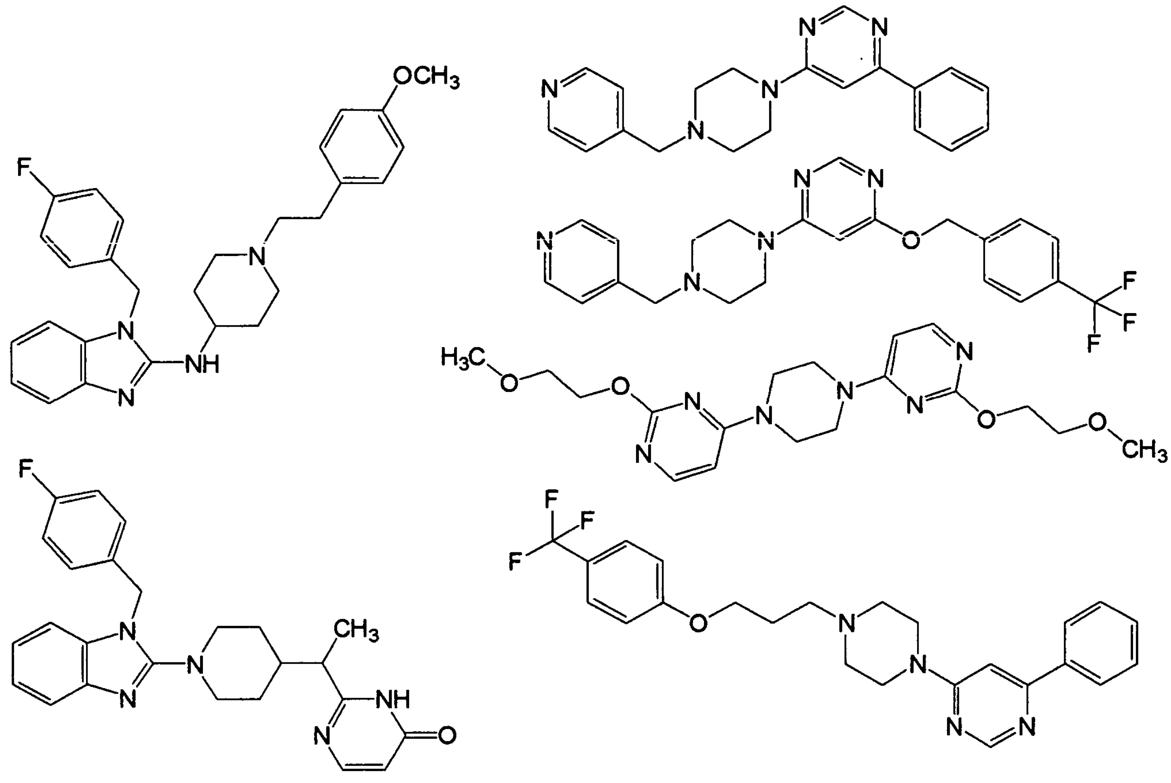

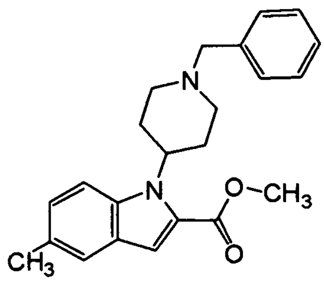

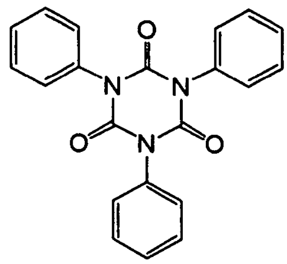

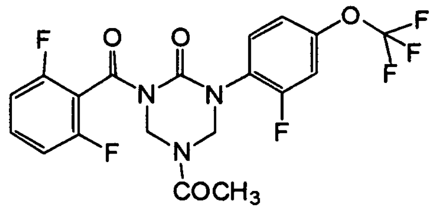

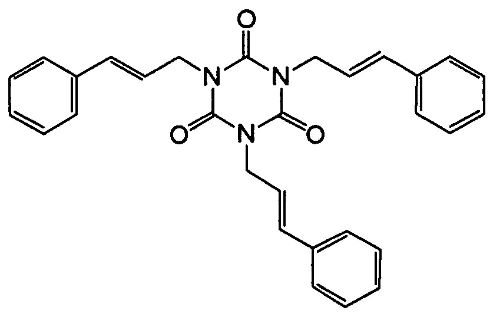

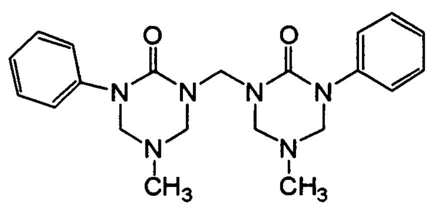

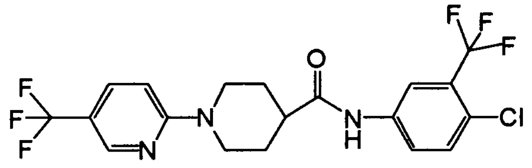

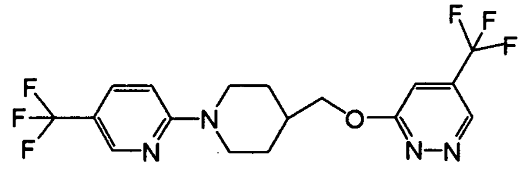

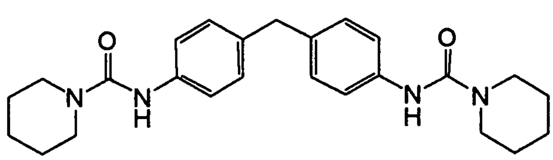

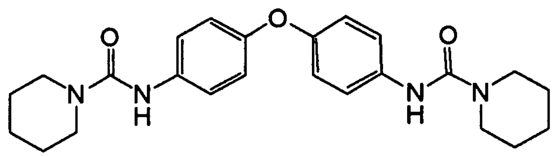

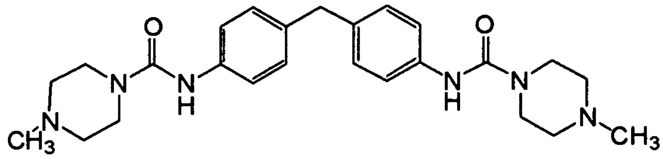

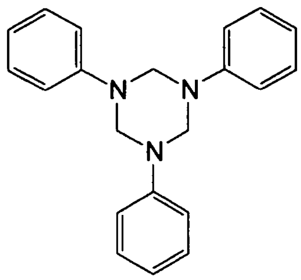

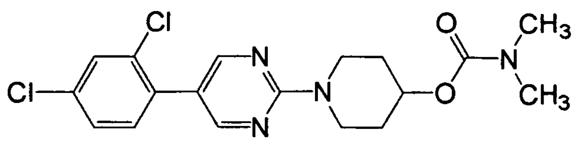

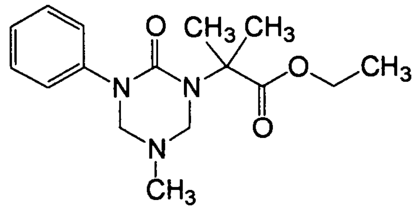

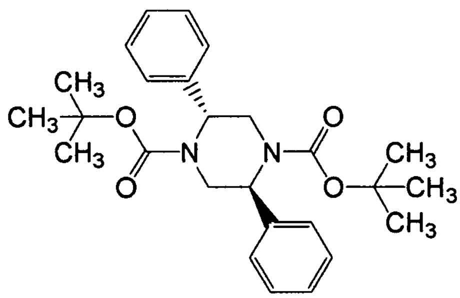

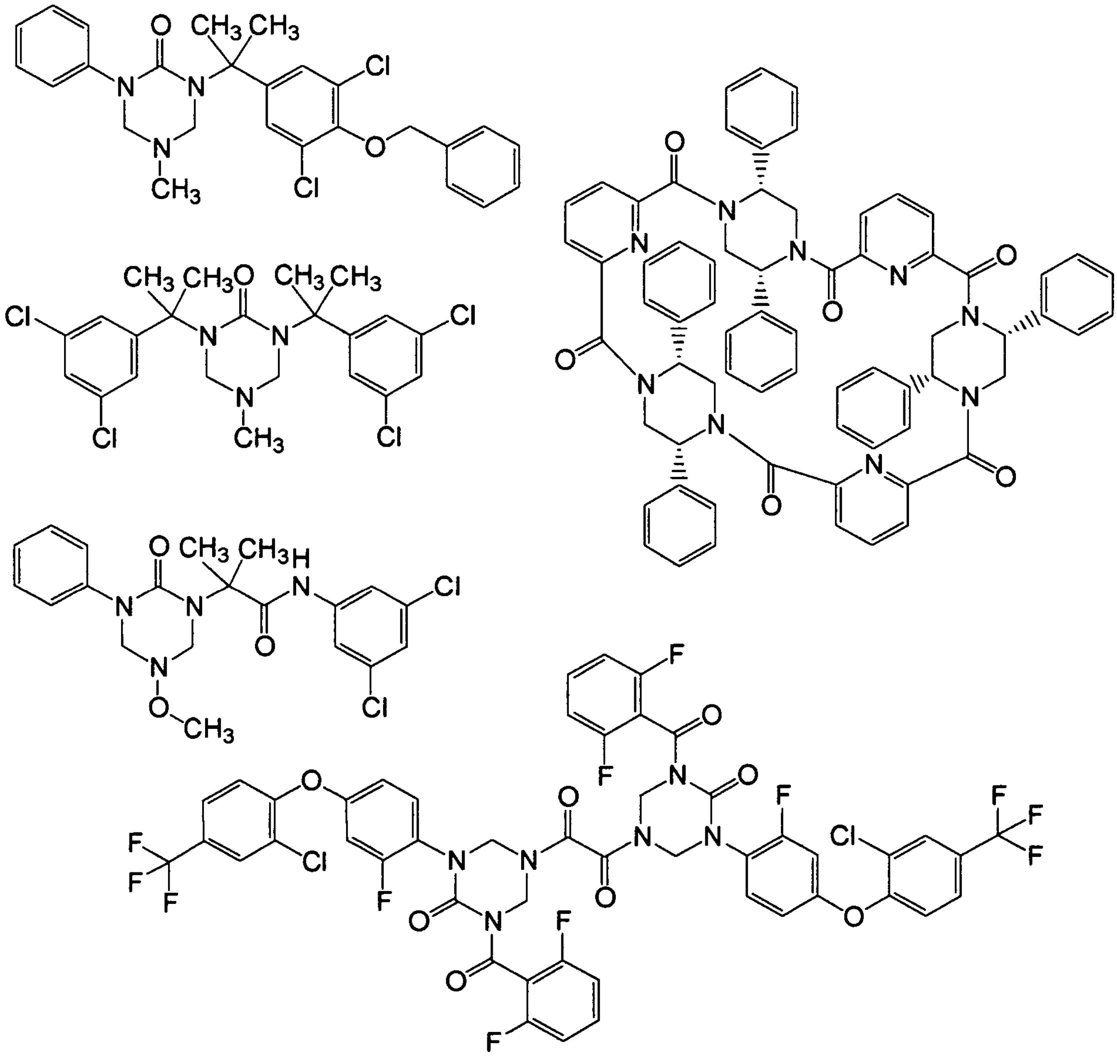

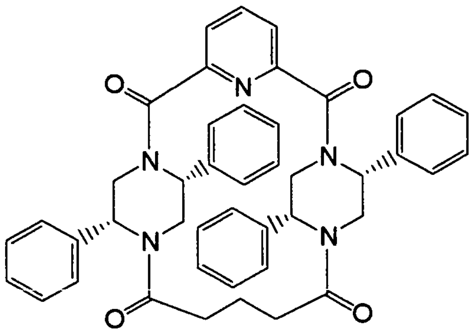

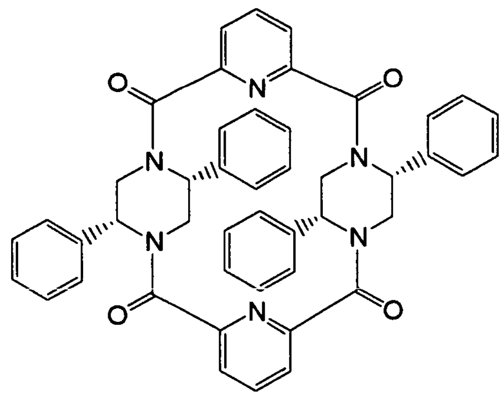

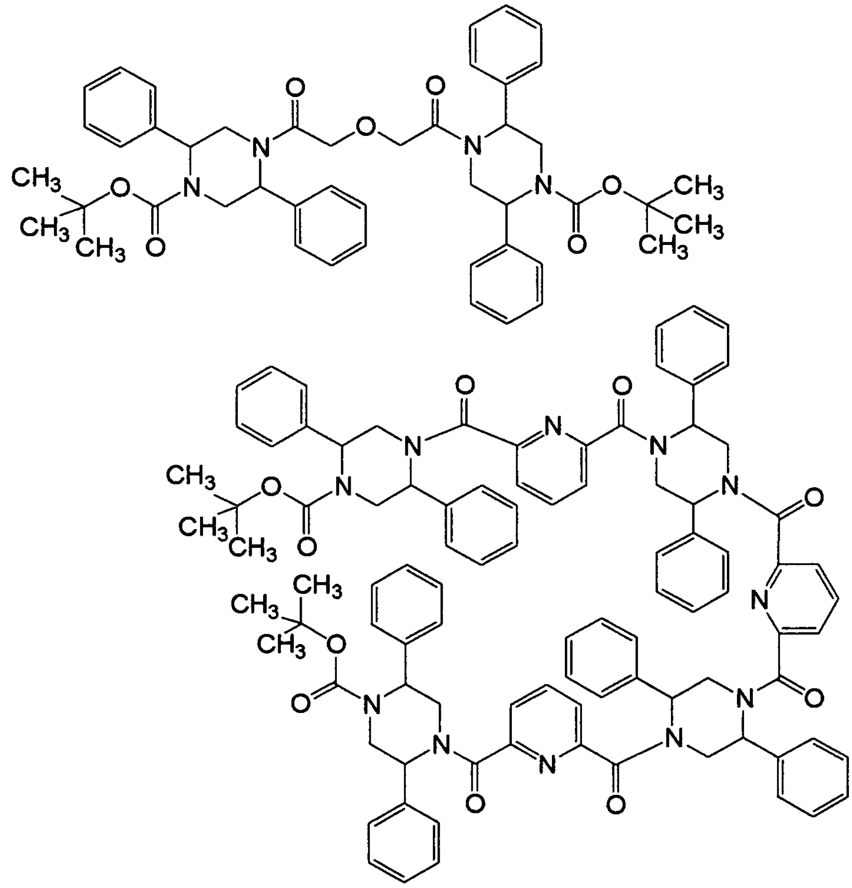

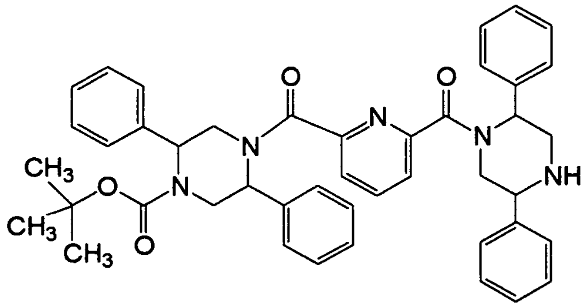

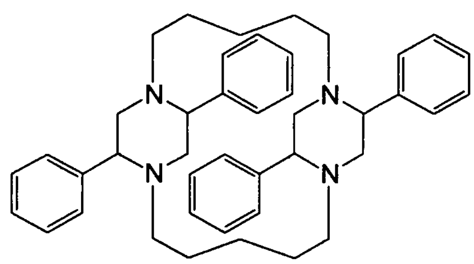

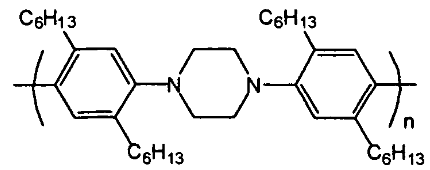

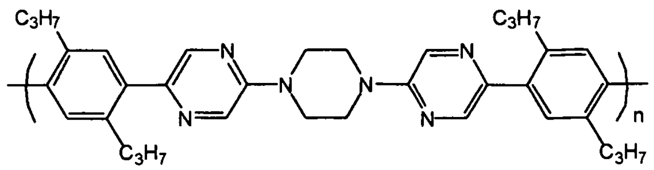

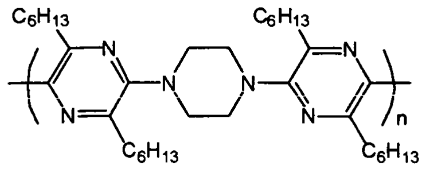

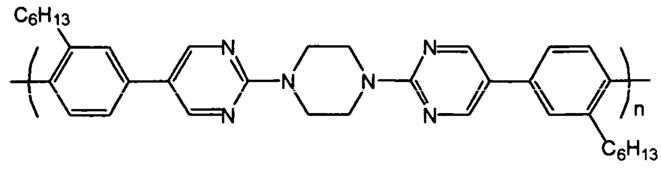

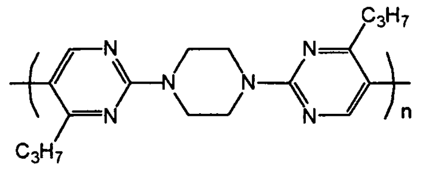

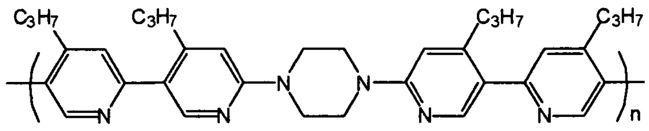

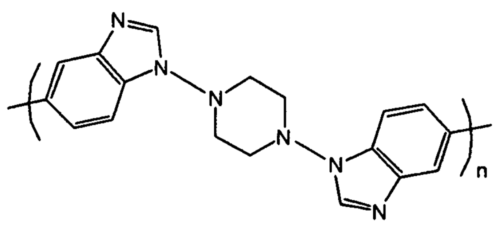

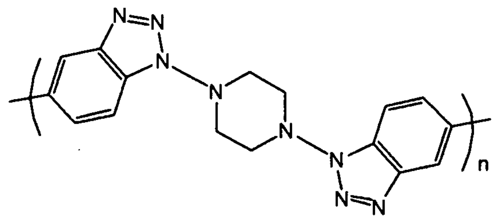

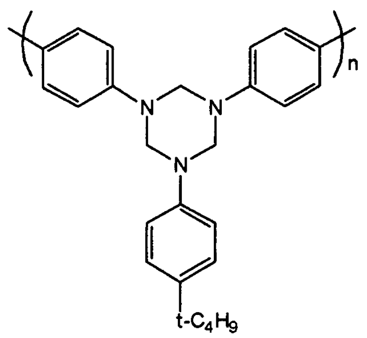

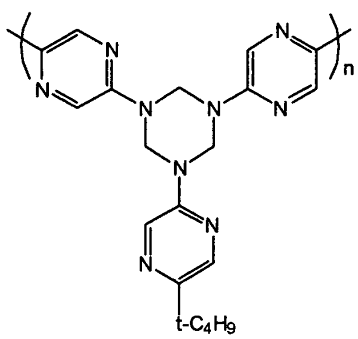

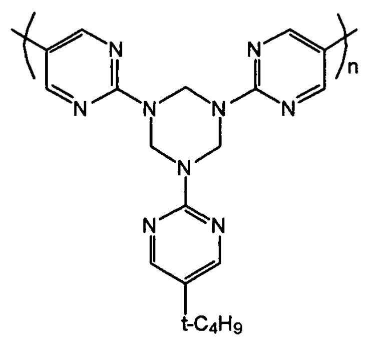

wherein n represents the number of polymerization units.

- Phosphorescent compound -

As the phosphorescent compound, known compounds such as a triplet emission complex can be used. For example, a compound conventionally used as a low-molecular weight EL luminous material is mentioned. These are disclosed, for example, in Nature, (1998), 395, 151, Appl. Phys. Lett. (1999), 75(1), 4, Proc. SPIE-Int. Soc. Opt. Eng. (2001), 4105 (Organic Light-Emitting Materials and DevicesIV), 119, J. Am. Chem. Soc., (2001), 123, 4304, Appl. Phys. Lett., (1997), 71(18), 2596, Syn. Met., (1998), 94(1), 103, Syn. Met., (1999), 99(2), 1361, Adv. Mater., (1999), 11(10), 852, Inorg. Chem., (2003), 42, 8609, Inorg. Chem., (2004), 43, 6513, Journal of the SID 11/1, 161 (2003), WO2002/066552, WO2004/020504, and WO2004/020448. Of these, the total of a square of an orbital coefficient of the outermost shell d-orbital of the central metal in the HOMO of a metal complex preferably occupies not less than 1/3 ratio of the total of a square of orbital coefficients of all atoms in order to obtain a high luminous efficiency. For example, ortho-metalated complexes, which is a transition metal having a central metal belonging to the 6th period, are mentioned.

The central metal of the triplet emission complex, which is usually a metal atom of an atomic number of 50 or more, having a spin-orbit interaction with the complex and capable of causing the intersystem crossing between a singlet state and a triplet state, include preferably atoms such as gold, platinum, iridium, osmium, rhenium, tungsten, europium, terbium, thulium, dysprosium, samarium, praseodymium, gadolinium and ytterbium; more preferably atoms such as gold, platinum, iridium, osmium, rhenium and tungsten; further preferably atoms such as gold, platinum, iridium, osmium

and rhenium; particularly preferably atoms such as gold, platinum, iridium and rhenium, and especially preferably atoms such as platinum and iridium.

Examples of the ligand of the triplet emission complex include 8-quinolinol and a derivative thereof, benzoquinolinol and a derivative thereof, and 2-phenyl-pyridine and a derivative thereof.

As the phosphorescent compound, in view of solubility, a compound having a substituent such as an alkyl group, an alkoxy group, an aryl group that may have a substituent and a heteroaryl group that may have a substituent are preferable. Furthermore, the substituent preferably has 3 or more atoms in total, except a hydrogen atom, more preferably 5 or more, further preferably 7 or more, and particularly preferably 10 or more. Furthermore, at least one of the substituents is preferably present in each ligand. The types of substituents may be the same or different per ligand.

As the phosphorescent compound, the following compounds are mentioned.

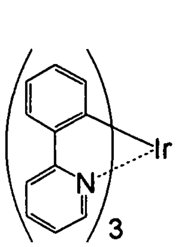
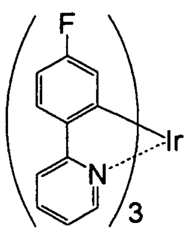
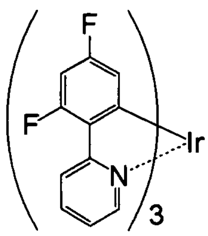
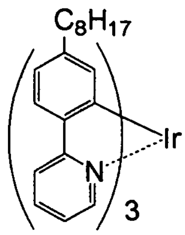
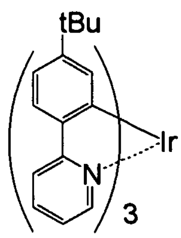

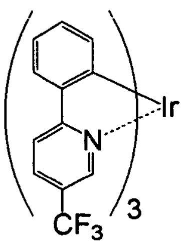
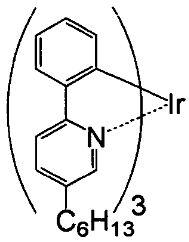
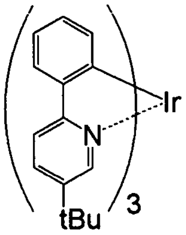
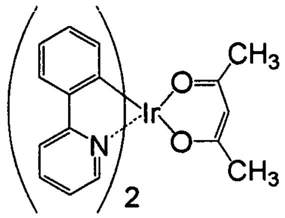

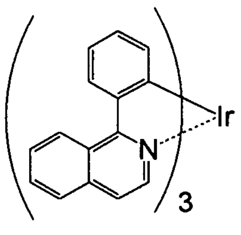
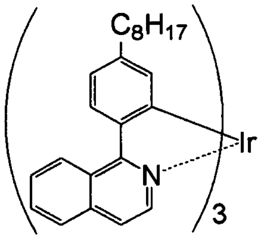
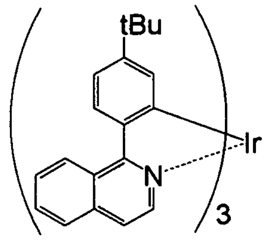
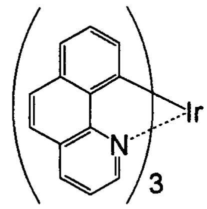

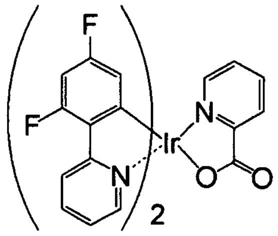
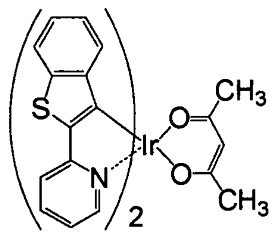
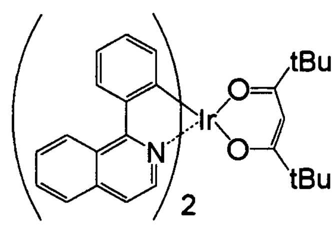

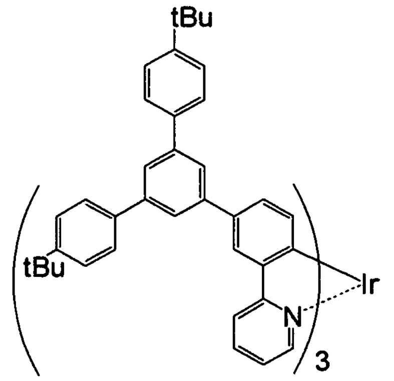

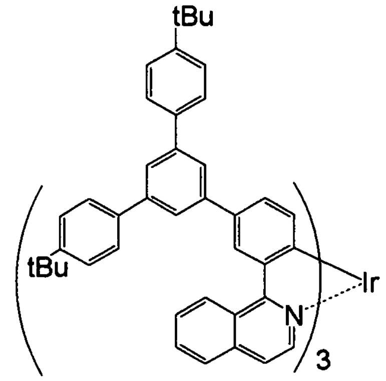

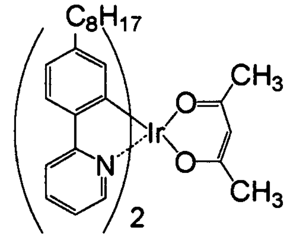

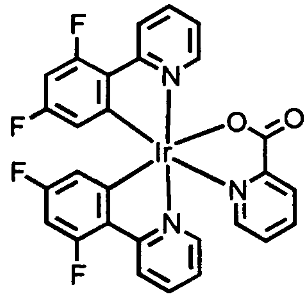

wherein tBu represents a tert-butyl group.

The content of phosphorescent compound in the composition of the present invention is usually, 0.01 to 80 parts by weight, based on 100 parts by weight of the compound having a saturated heterocyclic structure, preferably, 0.1 to 30 parts by weight, more preferably, 0.1 to 15 parts by weight, and particularly preferably, 0.1 to 10 parts by weight. Note that in the composition of the present invention, the compound having a saturated heterocyclic structure and the phosphorescent compound may each be used alone or in combination of two or more thereof.

The composition of the present invention may contain an optional component other than the compound having a saturated heterocyclic structure and the phosphorescent compound as long as the object of the invention is not damaged. As the optional component, for example, a hole transport material, an electron transport material and an antioxidant are mentioned.

Examples of the hole transport material include well-known hole transport materials for a light-emitting device such as an organic EL device, such as an aromatic amine, a carbazole derivative and a polyparaphenylene derivative.

Examples of the electron transport material include well-known electron transport materials for a light-emitting device such as an organic EL device, such as metal complexes of an oxadiazole derivative, anthraquinodimethane and a derivative thereof, benzoquinone and a derivative thereof, naphthoquinone and a derivative thereof, anthraquinone and a derivative thereof, tetracyanoanthraquinodimethane and a derivative thereof, a fluorenone derivative, diphenyldicyanoethylene and a derivative thereof, a diphenoquinone derivative, and 8-hydroxyquinoline and a derivative thereof.

In the composition of the present invention, the $T_1$ energy value (ETP) of the compound having a saturated heterocyclic structure and the $T_1$ energy value (ETT) of the phosphorescent compound preferably satisfy the following expression:

$$\mathrm{ETP} > \mathrm{ETT} \quad (\mathrm{eV})$$

in view of highly efficient light emission, more preferably satisfy

$$\mathrm{ETP} > \mathrm{ETT} + 0.1 \ (\mathrm{eV})$$

and further preferably

$$ETP > ETT+0.2 (eV).$$

<Polymer>

The polymer compound of the present invention is a polymer compound having a residue of a compound represented by a formula selected from the group consisting of the above formulas (1-1), (1-2), (1-3), (2-1), (2-2), (2-3) and (2-4) and a residue of the phosphorescent compound. The phosphorescent compound and the compound having a saturated heterocyclic structure are the same as described and exemplified in the section of the composition. The polymer compound of the present invention may have a residue of the phosphorescent compound in any one of the main chain, an end and a side chain of the molecular chain.

<Thin film>

Examples of the thin film of the present invention include a luminous thin film and an organic semiconductor thin film. These thin films are formed of the composition, etc. of the present invention.
The thin film of the present invention can be prepared by solution coating, vapor deposition and transfer, etc. As the solution coating, a spin coating method, a casting method, a microgravure coating method, a gravure coating method, a bar coating method, a roll coating method, a wire-bar coating method, dip coating method, a spray coating method, a screen printing method, a flexo printing method, an off-set printing method and an inkjet printing method etc. may be used.
As the solvent for use in a preparation of the solution, a solvent capable of dissolving or uniformly dispersing the composition, etc. of the present invention is preferable. Examples of the solvent include chlorine solvents (chloroform, methylene chloride, 1,2-dichloroethane, 1,1,2-trichloroethane, chlorobenzene, o-dichlorobenzene, etc.), ether solvents (tetrahydrofuran, dioxane, etc.), aromatic hydrocarbon solvents (toluene, xylene, etc.), aliphatic hydrocarbon solvents (cyclohexane, methylcyclohexane, n-pentane, n-hexane, n-heptane, n-octane, n-nonane, n-decane, etc.), ketone solvents (acetone, methyl ethyl ketone, cyclohexanone, etc.), ester solvents (ethyl acetate, butyl acetate, ethyl cellosolve acetate, etc.), polyhydric alcohols and derivatives thereof (ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin, 1,2-hexanediol, etc.), alcohol solvents (methanol, ethanol, propanol, isopropanol, cyclohexanol, etc.), sulfoxide solvents (dimethylsulfoxide, etc.) and amide solvents (N-methyl-2-pyrrolidone, N,N-dimethylformamide, etc.). These solvents may be used alone or in combination of two or more thereof
When the inkjet method is used, to improve ejection property from a head and uniformity, etc., a solvent in a solution and additives can be selected according to known methods. In this case, the viscosity of the solution is preferably 1 to 100 mPa·s at 25°C. Furthermore, if vaporization is significant, it tends to be difficult to repeat ejection from a head. In view of these, examples of a preferable solvent used include a single solvent or solvent mixture containing anisole, bicyclohexyl, xylene, tetralin and dodecyl benzene. Generally, a solution for inkjet suitable for a composition to be used can be obtained by a method of mixing a plurality of solvents, a method of controlling the concentration thereof in a solution of a composition and the like.

<Light-emitting device>

Next, the light-emitting device of the present invention will be described.
The light-emitting device of the present invention is prepared by using the composition, etc. of the present invention. Usually, the composition, etc. of the present invention are contained between electrodes consisting of an anode and a cathode. They are preferably contained as a light-emitting layer in the form of the thin film. Furthermore, in view of improving performance such as luminous efficiency and durability, a known layer having another function may be contained. Examples of such a layer include a charge transport layer (more specifically, hole transport layer, electron transport layer), a charge block layer (more specifically, hole block layer, electron block layer), a charge injection layer (more specifically, hole injection layer, electron injection layer), and a buffer layer. Note that in the light-emitting device of the present invention, the light-emitting layer, charge transport layer, charge block layer, charge injection layer and buffer layer, etc. each may be formed of a single layer or two or more layers.
The light-emitting layer is a layer having a function of emitting light. The hole transport layer is a layer having a function of transporting holes. The electron transport layer is a layer having a function of transporting electrons. The electron transport layer and the hole transport layer are collectively referred to as a charge transport layer. Furthermore, the charge block layer is a layer having a function of confining holes or electrons in the light-emitting layer. The layer for

transporting electrons and confining holes is referred to as a hole block layer and a layer for transporting holes and confining electrons is referred to as an electron block layer.

As the buffer layer, a layer provided in adjacent to an anode and containing a conductive polymer compound is mentioned.

As specific examples of the light-emitting device of the present invention, the following structures a) to q) are mentioned.

a) Anode/light-emitting layer/cathode
b) Anode/hole transport layer/light-emitting layer/cathode
c) Anode/light-emitting layer/electron transport layer/cathode
d) Anode/light-emitting layer /hole block layer/cathode
e) Anode/hole transport layer/light-emitting layer/electron transport layer/cathode
f) Anode/charge injection layer/light-emitting layer/cathode
g) Anode/light-emitting layer/charge injection layer/cathode
h) Anode/charge injection layer/light-emitting layer/charge injection layer/cathode
i) Anode/charge injection layer/hole transport layer/light-emitting layer/cathode
j) Anode/hole transport layer/light-emitting layer/charge injection layer/cathode
k) Anode/charge injection layer/hole transport layer/light-emitting layer/charge injection layer/cathode
l) Anode/charge injection layer/light-emitting layer/electron transport layer/cathode
m) Anode/light-emitting layer/electron transport layer/charge injection layer/cathode
n) Anode/charge injection layer/light-emitting layer/electron transport layer/charge injection layer/cathode
o) Anode/charge injection layer/hole transport layer/light-emitting layer/electron transport layer/cathode
p) Anode/hole transport layer/light-emitting layer/electron transport layer/charge injection layer/cathode
q) Anode/charge injection layer/hole transport layer/light-emitting layer/electron transport layer/charge injection layer/cathode (herein, the symbol "/" means that layers are laminated next to each other. The same applies hereinafter. Note that the light-emitting layer, hole transport layer and electron transport layer may each independently be formed of two or more thereof).

In the case where the light-emitting device of the present invention has a hole transport layer (usually, the hole transport layer contains a hole transport material), known materials are mentioned as the hole transport material. Examples thereof include polymer hole transport materials such as polyvinylcarbazole and a derivative thereof, polysilane and a derivative thereof, polysiloxane derivative having an aromatic amine in a side chain or the main chain, a pyrazoline derivative, an arylamine derivative, a stilbene derivative, a triphenyldiamine derivative, polyaniline and a derivative thereof, polythiophene and a derivative thereof, polypyrrole and a derivative thereof, poly(p-phenylenevinylene) and a derivative thereof, and poly(2,5-thienylenevinylene) and a derivative thereof; and further include the compounds described in JP 63-70257 A, JP 63-175860 A, JP 2-135359 A, JP 2-135361 A, JP 2-209988 A, JP 3-37992 A and JP 3-152184A.

In the case where the light-emitting device of the present invention has an electron transport layer (usually, the electron transport layer contains an electron transport material), known materials are mentioned as the electron transport material. Examples thereof include an oxadiazole derivative, anthraquinodimethane and a derivative thereof, benzoquinone and a derivative thereof, naphthoquinone and a derivative thereof, anthraquinone and a derivative thereof, tetracyanoanthraquinodimethane and a derivative thereof, a fluorenone derivative, diphenyldicyanoethylene and a derivative thereof, a diphenoquinone derivative, 8-hydroxyquinoline and a complex of a derivative thereof, polyquinoline and a derivative thereof, polyquinoxaline and a derivative thereof, and polyfluorene and a derivative thereof.

The film thicknesses of the hole transport layer and electron transport layer, whose optimum values thereof vary depending upon the material to be used, may be appropriately selected so as to obtain an appropriate driving voltage and luminous efficiency; however, the thickness is required to be sufficiently thick such that at least pin holes are not formed. If the film is extremely thick, the driving voltage of the device becomes high and thus not preferable. Therefore, the film thicknesses of the hole transport layer and electron transport layer are for example, 1 nm to 1 $\mu$m, preferably 2 nm to 500 nm, and further preferably 5 nm to 200 nm.

Furthermore, of the charge transport layers provided in adjacent to an electrode, a charge transport layer having a function of improving a charge injection efficiency from the electrode and an effect of reducing the driving voltage of the device, is sometimes called particularly as a charge injection layer (that is, a general name of a hole injection layer, and an electron injection layer. The same applies hereinafter).

Furthermore, to improve adhesion with an electrode and improve charge injection form an electrode, the charge injection layer or an insulating layer may be provided in adjacent to the electrode (usually, having an average thickness of 0.5 nm to 4 nm). Furthermore, to improve the adhesion of the interface and prevent contamination, etc., a thin buffer layer may be inserted into the interface of a charge transport layer and a light-emitting layer.

The lamination order of the layers and number of layers and the thickness of individual layers can be appropriately selected in consideration of luminous efficiency and the life of the device.

Examples of the charge injection layer include a layer containing a conductive polymer compound, a layer provided between an anode and a hole transport layer and having an intermediate ionization potential between an anode material and a hole transport material contained in the hole transport layer, and a layer provided between a cathode and an electron transport layer and having an intermediate electron affinity value between a cathode material and an electron transport material contained in the hole transport layer.

The material to be used in the charge injection layer may be appropriately selected in consideration of the materials of electrodes and adjacent layers. Examples thereof include polyaniline and a derivative thereof, polythiophene and a derivative thereof, polypyrrole and a derivative thereof, polyphenylenevinylene and a derivative thereof, polythienylenevinylene and a derivative thereof, polyquinoline and a derivative thereof, polyquinoxaline and a derivative thereof, a conductive polymer compound such as a polymer containing an aromatic amine structure in the main chain or a side chain, a metal phthalocyanine (copper phthalocyanine, etc.) and carbon.

The insulating layer has a function of facilitating charge injection. Examples of the material for the insulating layer include a metal fluoride, a metal oxide and an organic insulating material. As the light-emitting device having the insulating layer provided therein, a light-emitting device having an insulating layer provided in adjacent to a cathode and a light-emitting device having an insulating layer provided in adjacent to an anode are mentioned.

The light-emitting device of the present invention is usually formed on a substrate. Any substrate may be used as long as it does not change even if an electrode is formed thereon and an organic material layer is formed thereon. Examples thereof include glass, plastic, a polymer film and silicon. In the case of an opaque substrate, an opposite electrode is preferably transparent or semitransparent.

At least one of the anode and the cathode present in the light-emitting device of the present invention is usually transparent or semitransparent. Of them, the anode side is preferably transparent or semitransparent.

As a material for an anode, usually a conductive metal oxide film and a semitransparent metal thin film, etc. are used. Examples thereof include films (NESA, etc.) prepared by using conductive inorganic compounds such as indium oxide, zinc oxide, tin oxide, and a complex thereof, namely, indium tin oxide (ITO), indium zinc oxide; gold, platinum, silver and copper. ITO, indium zinc oxide, and tin oxide are preferable. As the preparation method thereof, a vacuum vapor deposition method, a sputtering method, an ion plating method and a plating method, etc. are mentioned. Furthermore, as the anode, an organic transparent conductive film of polyaniline and a derivative thereof, and polythiophene and a derivative thereof etc. may be used. Note that the anode may be formed of a laminate structure of 2 layers or more.

As a material for a cathode, usually, a material having a small work function is preferable. Example thereof include metals such as lithium, sodium, potassium, rubidium, cesium, beryllium, magnesium, calcium, strontium, barium, aluminum, scandium, vanadium, zinc, yttrium, indium, cerium, samarium, europium, terbium, ytterbium, and alloys formed from at least two of metals selected from them or alloys of at least one of metals selected from them and at least one of gold, silver, platinum, copper, manganese, titanium, cobalt, nickel, tungsten and tin, graphite or a graphite intercalation compound. Specific examples of the alloy include a magnesium-silver alloy, a magnesium-indium alloy, a magnesium-aluminum alloy, an indium-silver alloy, a lithium-aluminum alloy, a lithium-magnesium alloy, a lithium-indium alloy, a calcium-aluminum alloy. Note that the cathode may be formed of a laminate structure of 2 layers or more.

The light-emitting device of the present invention can be used, for example, as a planar light source, a display apparatus (for example, a segment display apparatus, a dot matrix display apparatus, a liquid crystal display apparatus) and backlights thereof (for example, a liquid crystal display apparatus having the light-emitting device as a backlight).

To obtain planer emission of light using the light-emitting device of the present invention, a planar anode and cathode are arranged so as to overlap them. Furthermore, to obtain patterned emission of light, there are a method of placing a mask having a patterned window on the surface of the planar light-emitting device, a method of forming an extremely thick organic material layer in a non light-emitting section such that light is not substantially emitted, and a method of forming a patterned electrode as either one of an anode and cathode or both electrodes. Patterns are formed by any one of these methods and electrodes are arranged so as to independently turn ON/OFF. In this manner, a segment-type display device capable of displaying numeric characters and letters, and simple symbols, etc. can be obtained. Furthermore, to obtain a dot matrix device, an anode and a cathode are formed in the form of stripe and arranged so as to cross perpendicularly. A partial color display and multi color display can be provided by a method of distinctively applying a plurality of light-emitting materials different in luminous color and a method of using a color filter or a fluorescence conversion filter. A dot-matrix device can be passively driven or may be actively driven in combination with TFT, etc. These display devices can be used as display apparatuses for computers, televisions, mobile terminals, mobile phones, car-navigation and view finders of video cameras, etc.

Furthermore, the planar light-emitting device is usually an autonomous light-emitting thin device and can be preferably used as a planar light source for a backlight of a liquid crystal display apparatus and light (for example, planar light, a light source for planar light), etc. Furthermore, if a flexible substrate is used, the light-emitting device can be used

as a curved-surface light source, light and a display apparatus, etc.

The composition, etc. of the present invention are not only useful for preparing a device but can be also used as a semiconductor material such as an organic semiconductor material, a light-emitting material, an optical material and a conductive material (for example, applied by doping). Accordingly, thin films such as light-emitting thin film, a conductive thin film and an organic semiconductor thin film can be prepared by using the composition, etc. of the present invention.

The composition, etc. of the present invention can be used to form a conductive thin film and a semiconductor thin film in the same manner as in a preparation method for a thin film (light-emitting thin film) to be used in the light emitting layer of the light-emitting device, and formed into a device. In the semiconductor thin film, a larger value of an electron mobility or hole mobility is preferably not less than $10^{-5}$ $cm^2/V/second$. Furthermore, an organic semiconductor thin film can be used in organic solar batteries and organic transistors, etc.

EXAMPLES

Hereinafter, Examples will be described to explain the present invention more specifically; however, the present invention is not limited to these.

<Example 1>

With a THF solution (0.05 wt%) of a phosphorescent compound (MC-1) synthesized by the method described in WO02/06655 and represented by the following formula:

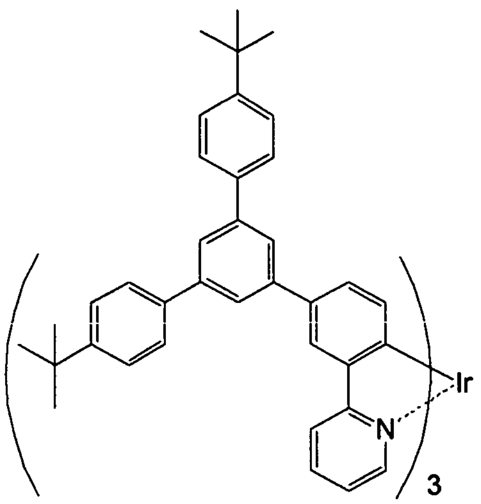

(MC-1)

about a 5-fold weight of a THF solution (about 1 wt%) of a compound (C-1) represented by the following formula:

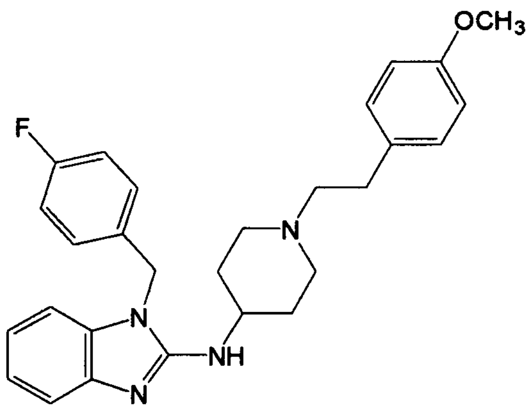

(C-1)

was mixed to prepare a mixture (solution). This mixture (10 μl) was added dropwise to a slide glass and air-dried to obtain a solid film. When the solid film was irradiated with UV rays of 365 nm, strong green light was emitted from the phosphorescent compound (MC-1). From this, it was confirmed that the luminous efficiency of the mixture is high.

The $T_1$ energy value of the compound (C-1) was 3.6 eV. The absolute value $E_{HOMO}$ of an HOMO energy level was 5.9 eV Furthermore, the $T_1$ energy value of phosphorescent compound (MC-1) was 2.7 eV

Parameters were calculated by the computational scientific approach described in the Detailed Description of the Invention. To describe more specifically, structure optimization was applied to the compound (C-1) by the HF method. At this time, as the basis function, 6-31G* was used. Thereafter, a value of an HOMO energy level and $T_1$ energy value were calculated by a B3P86-level time-dependent density functional method using the same basis function.

<Example 2>

With a THF solution (0.05 wt%) of the phosphorescent compound (MC-1), an about 5-fold weight of a THF solution (about 1 wt%) of a compound (C-2) represented by the following formula:

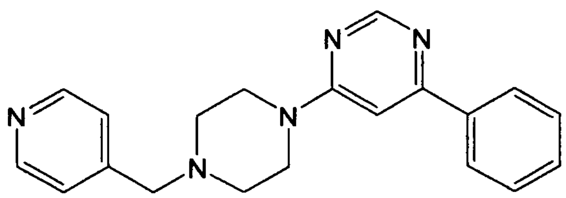

**(C-2)**

was mixed to prepare a mixture (solution). The mixture (10 μl) was added dropwise to a slide glass and air-dried to obtain a solid film. When the solid film was irradiated with UV rays of 365 nm, strong green light was emitted from the phosphorescent compound (MC-1). From this, it was confirmed that the luminous efficiency of the mixture is high.

Parameters were calculated by the computational scientific approach in the same manner as in Example 1. The $T_1$ energy value of the compound (C-2) was 3.4 eV and an absolute value $E_{LUMO}$ of an LUMO energy level was 1.7 eV

<Example 3>

With a THF solution (0.05 wt%) of the phosphorescent compound (MC-1), an about 5-fold weight of a THF solution (about 1 wt%) of a compound (C-3) represented by the following formula:

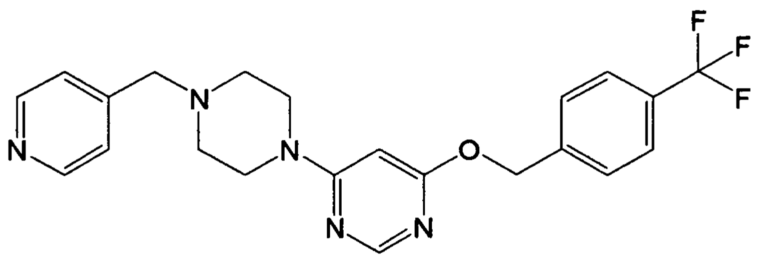

**(C-3)**

was mixed to prepare a mixture (solution). The mixture (10 μl) was added dropwise to a slide glass and air-dried to obtain a solid film. When the solid film was irradiated with UV rays of 365 nm, strong green light was emitted from the phosphorescent compound (MC-1). From this, it was confirmed that the luminous efficiency of the mixture is high.

Parameters were calculated by the computational scientific approach in the same manner as in Example 1. The $T_1$ energy value of the compound (C-3) was 3.8 eV

<Example 4>

With a THF solution (0.05 wt%) of the phosphorescent compound (MC-1), an about 5-fold weight of a THF solution (about 1 wt%) of a compound (C-4) represented by the following formula:

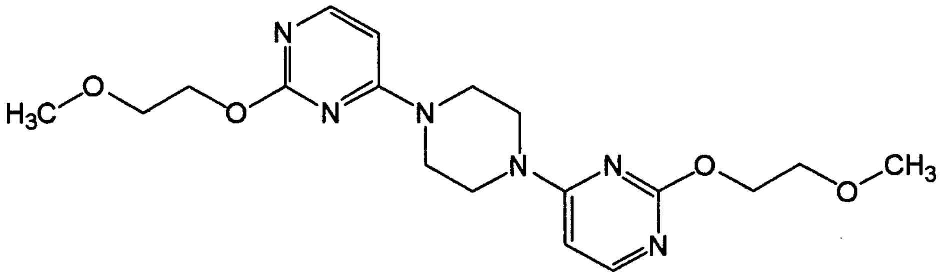

(C-4)

was mixed to prepare a mixture (solution). The mixture (10 μl) was added dropwise to a slide glass and air-dried to obtain a solid film. When the solid film was irradiated with UV rays of 365 nm, strong green light was emitted from the phosphorescent compound (MC-1). From this, it was confirmed that the luminous efficiency of the mixture is high.
Parameters were calculated by the computational scientific approach in the same manner as in Example 1. The $T_1$ energy value of the compound (C-4) was 4.0 eV

<Example 5>

A mixture (solution) was prepared in the same manner as in Example 1 except that the phosphorescent compound (MC-1) in Example 1 was replaced with a phosphorescent compound (MC-2) represented by the following formula:

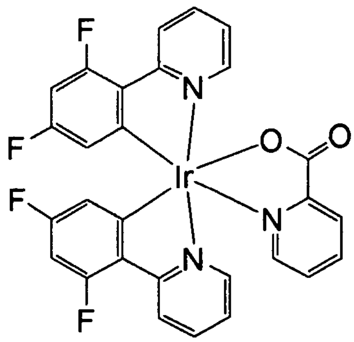

(MC-2)

When the resultant solid film was irradiated with UV rays of 254 nm, intensive light was emitted from the phosphorescent compound (MC-2, trade name: ADS065BE manufactured by American Dye Source, Inc.). From this, it was confirmed that the luminous efficiency of the mixture is high.
The $T_1$ energy value of the phosphorescent compound (MC-2) calculated by the computational scientific approach was 2.9 eV

<Example 6>

A mixture (solution) was prepared in the same manner as in Example 2 except that the phosphorescent compound (MC-1) in Example 2 was replaced with the phosphorescent compound (MC-2). When the resultant solid film was irradiated with UV rays of 365 nm, intensive light was emitted from the phosphorescent compound (MC-2). From this, it was confirmed that the luminous efficiency of the mixture is high.

<Example 7>

A mixture (solution) was prepared in the same manner as in Example 3 except that the phosphorescent compound (MC-1) in Example 3 was replaced with the phosphorescent compound (MC-2). When the resultant solid film was irradiated with UV rays of 254 nm, intensive light was emitted from the phosphorescent compound (MC-2). From this, it was confirmed that the luminous efficiency of the mixture is high.

<Example 8>

A mixture (solution) was prepared in the same manner as in Example 4 except that the phosphorescent compound (MC-1) in Example 4 was replaced with the phosphorescent compound (MC-2). When the resultant solid film was irradiated with UV rays of 365 nm, intensive light was emitted from the phosphorescent compound (MC-2). From this, it was confirmed that the luminous efficiency of the mixture is high.

<Example 9>

With a THF solution (0.05 wt%) of the phosphorescent compound (MC-1), an about 5-fold weight of a THF solution (about 1 wt%) of a compound (C-5) represented by the following formula:

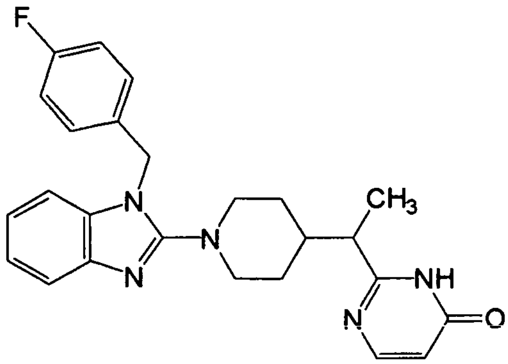

(C-5)

was mixed to prepare a mixture (solution). The mixture (10 μl) was added dropwise to a slide glass and air-dried to obtain a solid film. When the solid film was irradiated with UV rays of 365 nm, intensive light was emitted from the phosphorescent compound (MC-1). From this, it was confirmed that the luminous efficiency of the mixture is high. Parameters were calculated by the computational scientific approach in the same manner as in Example 1. The $T_1$ energy value of the compound (C-5) was 3.4 eV and the absolute value $E_{LUMO}$ of an LUMO energy level was 1.5 eV.

<Example 10>

With a THF solution (0.05 wt%) of the phosphorescent compound (MC-1), an about 5-fold weight of a THF solution (about 1 wt%) of a compound (C-6) represented by the following formula:

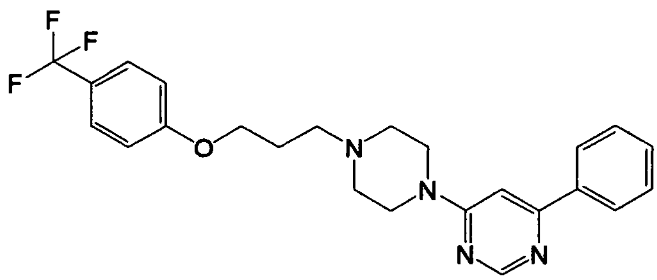

(C-6)

was mixed to prepare a mixture (solution). The mixture (10 μl) was added dropwise to a slide glass and air-dried to obtain a solid film. When the solid film was irradiated with UV rays of 365 nm, intensive light was emitted from the phosphorescent compound (MC-1). From this, it was confirmed that the luminous efficiency of the mixture is high. Parameters were calculated by the computational scientific approach in the same manner as in Example 1. The $T_1$ energy value of the compound (C-6) was 3.4 eV and the absolute value $E_{LUMO}$ of an LUMO energy level was 1.7 eV

<Example 11>

With a THF solution (0.05 wt%) of the phosphorescent compound (MC-1), an about 5-fold weight of a THF

solution (about 1 wt%) of a compound (C-7) represented by the following formula:

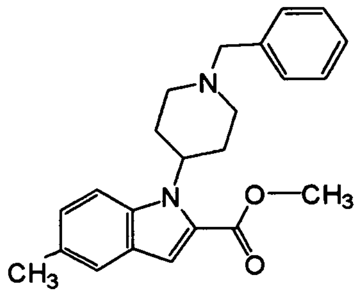

(C-7)

was mixed to prepare a mixture (solution). The mixture (10 μl) was added dropwise to a slide glass and air-dried to obtain a solid film. When the solid film was irradiated with UV rays of 365 nm, intensive light was emitted from the phosphorescent compound (MC-1). From this, it was confirmed that the luminous efficiency of the mixture is high.

<Example 12>

With a THF solution (0.05 wt%) of the phosphorescent compound (MC-1), an about 5-fold weight of a THF solution (about 1 wt%) of a compound (C-8) represented by the following formula:

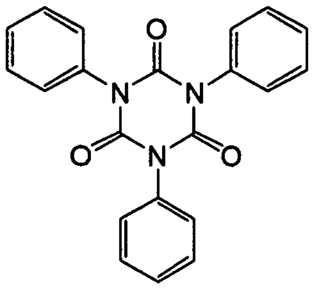

(C-8)

was mixed to prepare a mixture (solution). The mixture (10 μl) was added dropwise to a slide glass and air-dried to obtain a solid film. When the solid film was irradiated with UV rays of 365 nm, intensive light was emitted from the phosphorescent compound (MC-1). From this, it was confirmed that the luminous efficiency of the mixture is high. Parameters were calculated by the computational scientific approach in the same manner as in Example 1. The $T_1$ energy value of the compound (C-8) was 3.8 eV

<Example 13>

With a THF solution (0.05 wt%) of the phosphorescent compound (MC-1), an about 5-fold weight of a THF solution (about 1 wt%) of a compound (C-9) represented by the following formula:

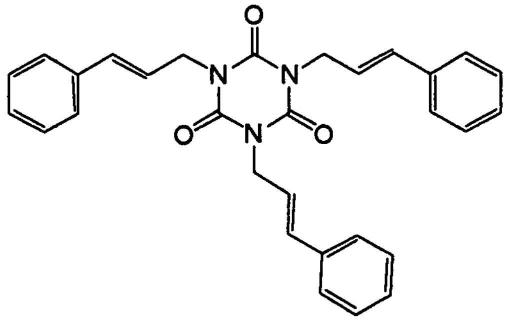

(C-9)

was mixed to prepare a mixture (solution). The mixture (10 μl) was added dropwise to a slide glass and air-dried to obtain a solid film. When the solid film was irradiated with UV rays of 365 nm, intensive light was emitted from the phosphorescent compound (MC-1). From this, it was confirmed that the luminous efficiency of the mixture is high. Parameters were calculated by the computational scientific approach in the same manner as in Example 1. The $T_1$ energy value of the compound (C-9) was 3.1 eV and the absolute value $E_{LUMO}$ of an LUMO energy level was 1.5 eV

<Example 14>

With a THF solution (0.05 wt%) of the phosphorescent compound (MC-1), an about 5-fold weight of a THF solution (about 1 wt%) of a compound (C-10) represented by the following formula:

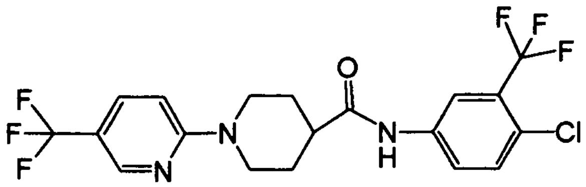

(C-10)

was mixed to prepare a mixture (solution). The mixture (10 μl) was added dropwise to a slide glass and air-dried to obtain a solid film. When the solid film was irradiated with UV rays of 365 nm, intensive light was emitted from the phosphorescent compound (MC-1). From this, it was confirmed that the luminous efficiency of the mixture is high. Parameters were calculated by the computational scientific approach in the same manner as in Example 1. The $T_1$ energy value of the compound (C-10) was 3.5 eV and the absolute value $E_{LUMO}$ of an LUMO energy level was 1.7 eV

<Example 15>

With a THF solution (0.05 wt%) of the phosphorescent compound (MC-1), an about 5-fold weight of a THF solution (about 1 wt%) of a compound (C-11) represented by the following formula:

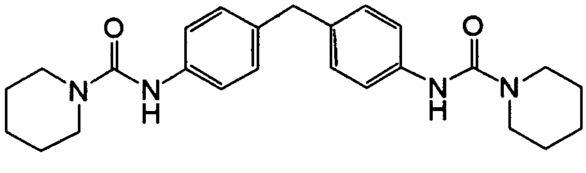

(C-11)

was mixed to prepare a mixture (solution). The mixture (10 μl) was added dropwise to a slide glass and air-dried to obtain a solid film. When the solid film was irradiated with UV rays of 365 nm, intensive light was emitted from the phosphorescent compound (MC-1). From this, it was confirmed that the luminous efficiency of the mixture is high. Parameters were calculated by the computational scientific approach in the same manner as in Example 1. The $T_1$ energy value of the compound (C-11) was 3.6 eV

<Example 16>

With a THF solution (0.05 wt%) of the phosphorescent compound (MC-1), an about 5-fold weight of a THF solution (about 1 wt%) of a compound ((C-12) represented by the following formula:

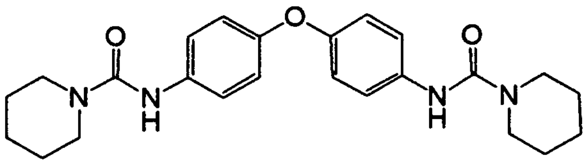

(C-12)

was mixed to prepare a mixture (solution). The mixture (10 μl) was added dropwise to a slide glass and air-dried to obtain a solid film. When the solid film was irradiated with UV rays of 365 nm, intensive light was emitted from the phosphorescent compound (MC-1). From this, it was confirmed that the luminous efficiency of the mixture is high. Parameters were calculated by the computational scientific approach in the same manner as in Example 1. The $T_1$ energy value of the compound (C-12) was 3.6 eV

<Example 17>

With a THF solution (0.05 wt%) of the phosphorescent compound (MC-1), an about 5-fold weight of a THF solution (about 1 wt%) of a compound (C-13) represented by the following formula:

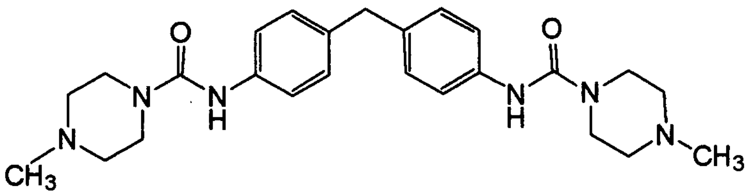

(C-13)

was mixed to prepare a mixture (solution). The mixture (10 μl) was added dropwise to a slide glass and air-dried to obtain a solid film. When the solid film was irradiated with UV rays of 365 nm, intensive light was emitted from the phosphorescent compound (MC-1). From this, it was confirmed that the luminous efficiency of the mixture is high. Parameters were calculated by the computational scientific approach in the same manner as in Example 1. The $T_1$ energy value of the compound (C-13) was 3.6 eV

<Example 18>

With a THF solution (0.05 wt%) of the phosphorescent compound (MC-1), an about 5-fold weight of a THF solution (about 1 wt%) of a compound (C-14) represented by the following formula:

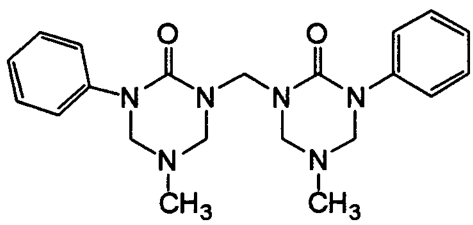

(C-14)

was mixed to prepare a mixture (solution). The mixture (10 μl) was added dropwise to a slide glass and air-dried to obtain a solid film. When the solid film was irradiated with UV rays of 365 nm, intensive light was emitted from the

phosphorescent compound (MC-1). From this, it was confirmed that the luminous efficiency of the mixture is high.
Parameters were calculated by the computational scientific approach in the same manner as in Example 1. The $T_1$ energy value of the compound (C-14) was 3.8 eV

<Example 19>

With a THF solution (0.05 wt%) of the phosphorescent compound (MC-1), an about 5-fold weight of a THF solution (about 1 wt%) of a compound (C-15) represented by the following formula:

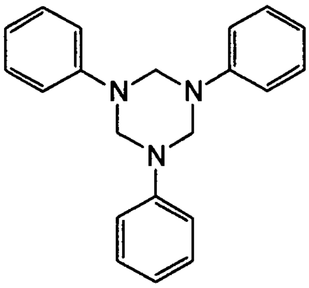

(C-15)

was mixed to prepare a mixture (solution). The mixture (10 μl) was added dropwise to a slide glass and air-dried to obtain a solid film. When the solid film was irradiated with UV rays of 365 nm, intensive light was emitted from the phosphorescent compound (MC-1). From this, it was confirmed that the luminous efficiency of the mixture is high.
Parameters were calculated by the computational scientific approach in the same manner as in Example 1. The $T_1$ energy value of the compound (C-15) was 3.6 eV

<Example 20>

With a THF solution (0.05 wt%) of the phosphorescent compound (MC-1), an about 5-fold weight of a THF solution (about 1 wt%) of a compound (C-16) represented by the following formula:

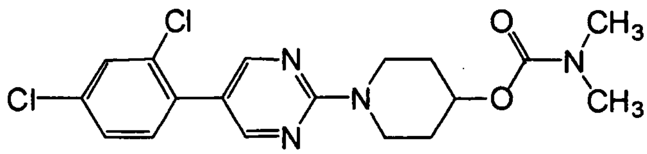

(C-16)

was mixed to prepare a mixture (solution). The mixture (10 μl) was added dropwise to a slide glass and air-dried to obtain a solid film. When the solid film was irradiated with UV rays of 365 nm, intensive light was emitted from the phosphorescent compound (MC-1). From this, it was confirmed that the luminous efficiency of the mixture is high.
Parameters were calculated by the computational scientific approach in the same manner as in Example 1. The $T_1$ energy value of the compound (C-16) was 3.4 eV and the absolute value $E_{LUMO}$ of an LUMO energy level was 1.5 eV

<Example 21>

With a THF solution (0.05 wt%) of the phosphorescent compound (MC-1), an about 5-fold weight of a THF solution (about 1 wt%) of a compound (C-17) represented by the following formula:

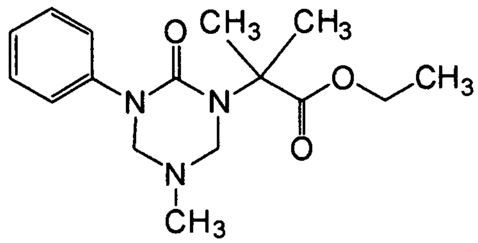

(C-17)

was mixed to prepare a mixture (solution). The mixture (10 μl) was added dropwise to a slide glass and air-dried to obtain a solid film. When the solid film was irradiated with UV rays of 365 nm, intensive light was emitted from the phosphorescent compound (MC-1). From this, it was confirmed that the luminous efficiency of the mixture is high. Parameters were calculated by the computational scientific approach in the same manner as in Example 1. The $T_1$ energy value of the compound (C-17) was 3.8 eV

<Example 22>

With a THF solution (0.05 wt%) of the phosphorescent compound (MC-1), an about 5-fold weight of a THF solution (about 1 wt%) of a compound (C-18) represented by the following formula:

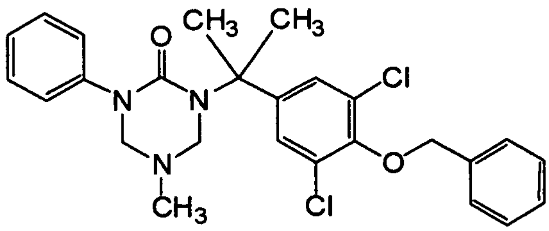

(C-18)

was mixed to prepare a mixture (solution). The mixture (10 μl) was added dropwise to a slide glass and air-dried to obtain a solid film. When the solid film was irradiated with UV rays of 365 nm, intensive light was emitted from the phosphorescent compound (MC-1). From this, it was confirmed that the luminous efficiency of the mixture is high. Parameters were calculated by the computational scientific approach in the same manner as in Example 1. The $T_1$ energy value of the compound (C-18) was 3.6 eV

<Example 23>

With a THF solution (0.05 wt%) of the phosphorescent compound (MC-1), an about 5-fold weight of a THF solution (about 1 wt%) of a compound (C-19) represented by the following formula:

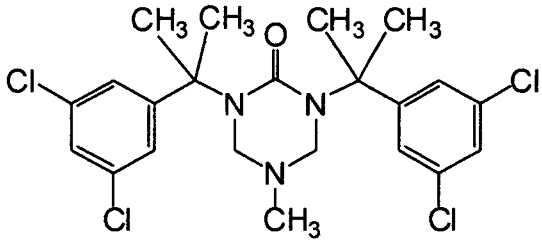

(C-19)

was mixed to prepare a mixture (solution). The mixture (10 μl) was added dropwise to a slide glass and air-dried to

obtain a solid film. When the solid film was irradiated with UV rays of 365 nm, intensive light was emitted from the phosphorescent compound (MC-1). From this, it was confirmed that the luminous efficiency of the mixture is high. Parameters were calculated by the computational scientific approach in the same manner as in Example 1. The $T_1$ energy value of the compound (C-19) was 3.6 eV and the absolute value $E_{LUMO}$ of an LUMO energy level was 1.5 eV.

<Example 24>

With a THF solution (0.05 wt%) of the phosphorescent compound (MC-1), an about 5-fold weight of a THF solution (about 1 wt%) of a compound (C-20) represented by the following formula:

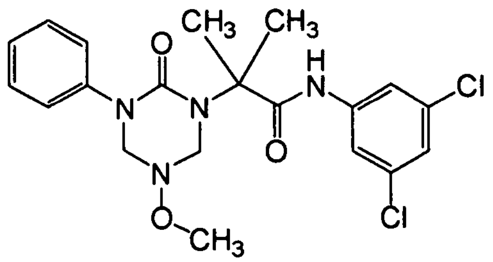

(C-20)

was mixed to prepare a mixture (solution). The mixture (10 μl) was added dropwise to a slide glass and air-dried to obtain a solid film. When the solid film was irradiated with UV rays of 365 nm, intensive light was emitted from the phosphorescent compound (MC-1). From this, it was confirmed that the luminous efficiency of the mixture is high. Parameters were calculated by the computational scientific approach in the same manner as in Example 1. The $T_1$ energy value of the compound (C-20) was 3.5 eV and the absolute value $E_{LUMO}$ of an LUMO energy level was 1.6 eV

<Example 25>

With a THF solution (0.05 wt%) of the phosphorescent compound (MC-1), an about 5-fold weight of a THF solution (about 1 wt%) of a compound (C-21) represented by the following formula:

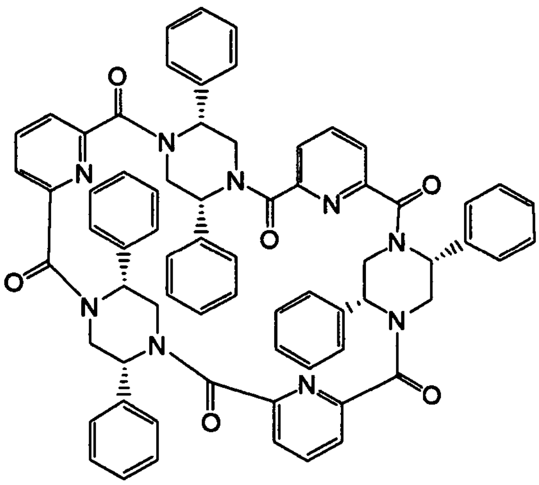

(C-21)

was mixed to prepare a mixture (solution). The mixture (10 μl) was added dropwise to a slide glass and air-dried to obtain a solid film. When the solid film was irradiated with UV rays of 365 nm, intensive light was emitted from the phosphorescent compound (MC-1). From this, it was confirmed that the luminous efficiency of the mixture is high. Parameters were calculated by the computational scientific approach in the same manner as in Example 1. The $T_1$ energy value of the compound (C-21) was 3.5 eV and the absolute value $E_{LUMO}$ of an LUMO energy level was 2.2 eV

<Example 26>

With a THF solution (0.05 wt%) of the phosphorescent compound (MC-1), an about 5-fold weight of a THF solution (about 1 wt%) of a compound (C-22) represented by the following formula:

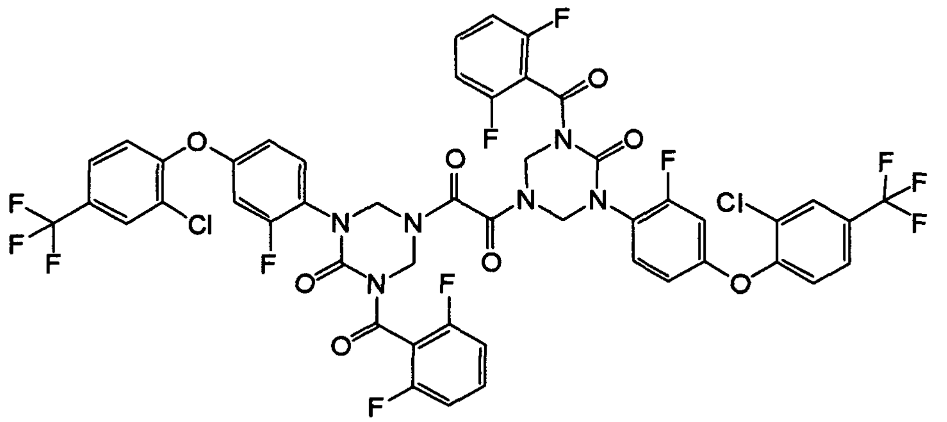

(C-22)

was mixed to prepare a mixture (solution). The mixture (10 μl) was added dropwise to a slide glass and air-dried to obtain a solid film. When the solid film was irradiated with UV rays of 365 nm, green light was emitted from the phosphorescent compound (MC-1). From this, it was confirmed that the luminous efficiency of the mixture is high.
Parameters were calculated by the computational scientific approach in the same manner as in Example 1. The $T_1$ energy value of the compound (C-22) was 3.7 eV and the absolute value $E_{LUMO}$ of an LUMO energy level was 2.2 eV

<Example 27>

With a THF solution (0.05 wt%) of the phosphorescent compound (MC-1), an about 5-fold weight of a THF solution (about 1 wt%) of a compound (C-23) represented by the following formula:

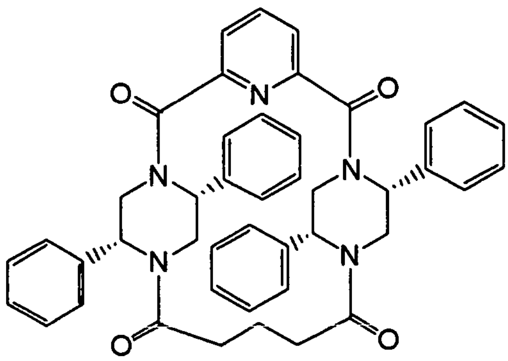

(C-23)

was mixed to prepare a mixture (solution). The mixture (10 μl) was added dropwise to a slide glass and air-dried to obtain a solid film. When the solid film was irradiated with UV rays of 365 nm, green light was emitted from the phosphorescent compound (MC-1). From this, it was confirmed that the luminous efficiency of the mixture is high.

<Example 28>

With a THF solution (0.05 wt%) of the phosphorescent compound (MC-1), an about 5-fold weight of a THF solution (about 1 wt%) of a compound (C-24) represented by the following formula:

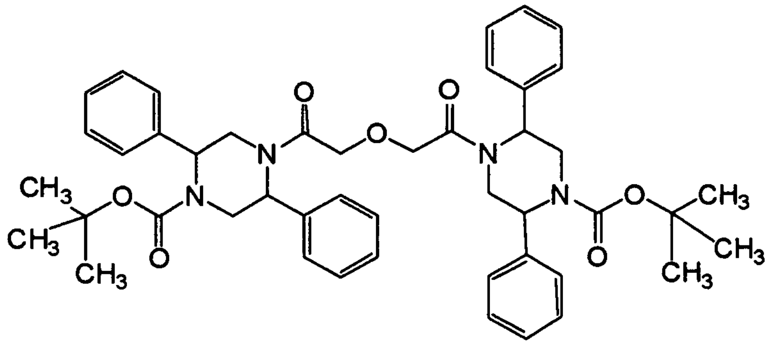

(C-24)

was mixed to prepare a mixture (solution). The mixture (10 μl) was added dropwise to a slide glass and air-dried to obtain a solid film. When the solid film was irradiated with UV rays of 365 nm, green light was emitted from the phosphorescent compound (MC-1). From this, it was confirmed that the luminous efficiency of the mixture is high.
Parameters were calculated by the computational scientific approach in the same manner as in Example 1. The $T_1$ energy value of the compound (C-24) was 3.8 eV

<Example 29>

With a THF solution (0.05 wt%) of the phosphorescent compound (MC-1), an about 5-fold weight of a THF solution (about 1 wt%) of a compound (C-25) represented by the following formula:

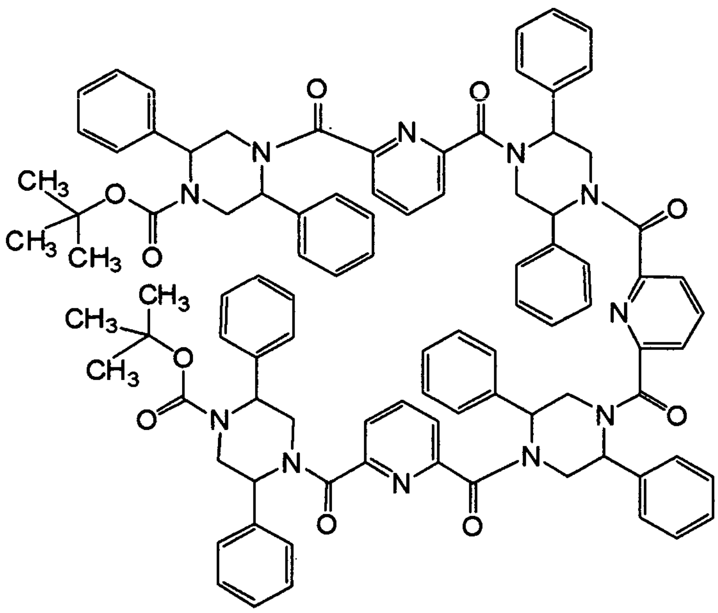

(C-25)

was mixed to prepare a mixture (solution). The mixture (10 μl) was added dropwise to a slide glass and air-dried to obtain a solid film. When the solid film was irradiated with UV rays of 365 nm, green light was emitted from the phosphorescent compound (MC-1). From this, it was confirmed that the luminous efficiency of the mixture is high.
Parameters were calculated by the computational scientific approach in the same manner as in Example 1. The $T_1$ energy value of the compound (C-25) was 3.6 eV and the absolute value $E_{LUMO}$ of an LUMO energy level was 1.9 eV

<Example 30>

With a THF solution (0.05 wt%) of the phosphorescent compound (MC-1), an about 5-fold weight of a THF solution (about 1 wt%) of a compound (C-26) represented by the following formula:

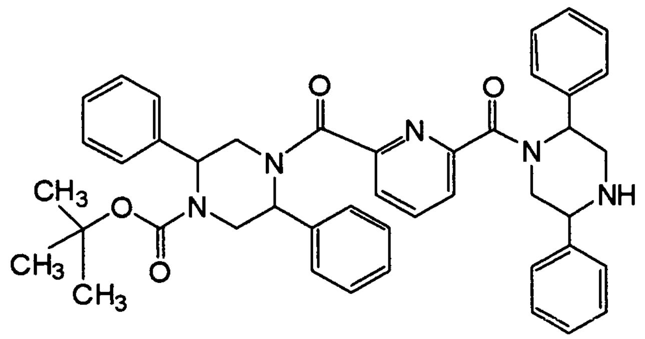

(C-26)

was mixed to prepare a mixture (solution). The mixture (10 μl) was added dropwise to a slide glass and air-dried to obtain a solid film. When the solid film was irradiated with UV rays of 365 nm, green light was emitted from the phosphorescent compound (MC-1). From this, it was confirmed that the luminous efficiency of the mixture is high.
Parameters were calculated by the computational scientific approach in the same manner as in Example 1. The $T_1$ energy value of the compound (C-26) was 3.5 eV and the absolute value $E_{LUMO}$ of an LUMO energy level was 1.9 eV

<Example 31>

With a THF solution (0.05 wt%) of the phosphorescent compound (MC-1), an about 5-fold weight of a THF solution (about 1 wt%) of a compound (C-27) represented by the following formula:

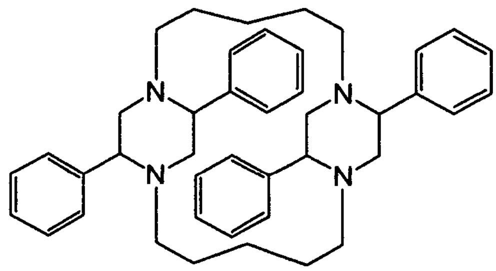

(C-27)

was mixed to prepare a mixture (solution). The mixture (10 μl) was added dropwise to a slide glass and air-dried to obtain a solid film. When the solid film was irradiated with UV rays of 365 nm, green light was emitted from the phosphorescent compound (MC-1). From this, it was confirmed that the luminous efficiency of the mixture is high.
Parameters were calculated by the computational scientific approach in the same manner as in Example 1. The $T_1$ energy value of the compound (C-27) was 3.8 eV

<Example 32>

A mixture (solution) was prepared in the same manner as in Example 9 except that the phosphorescent compound (MC-1) in Example 9 was replaced with the phosphorescent compound (MC-2). When the resultant solid film was irradiated with UV rays of 365 nm, intensive light was emitted from the phosphorescent compound (MC-2). From this, it was confirmed that the luminous efficiency of the mixture is high.

<Example 33>

A mixture (solution) was prepared in the same manner as in Example 10 except that the phosphorescent compound (MC-1) in Example 10 was replaced with the phosphorescent compound (MC-2). When the resultant solid film was irradiated with UV rays of 365 nm, intensive light was emitted from the phosphorescent compound (MC-2). From this, it was confirmed that the luminous efficiency of the mixture is high.

<Example 34>

A mixture (solution) was prepared in the same manner as in Example 14 except that the phosphorescent compound (MC-1) in Example 14 was replaced with the phosphorescent compound (MC-2). When the resultant solid film was irradiated with UV rays of 365 nm, intensive light was emitted from the phosphorescent compound (MC-2). From this, it was confirmed that the luminous efficiency of the mixture is high.

<Example 35>

A mixture (solution) was prepared in the same manner as in Example 22 except that the phosphorescent compound (MC-1) in Example 22 was replaced with the phosphorescent compound (MC-2). When the resultant solid film was irradiated with UV rays of 365 nm, intensive light was emitted from the phosphorescent compound (MC-2). From this, it was confirmed that the luminous efficiency of the mixture is high.

<Example 36>

A mixture (solution) was prepared in the same manner as in Example 23 except that the phosphorescent compound (MC-1) in Example 23 was replaced with the phosphorescent compound (MC-2). When the resultant solid film was irradiated with UV rays of 365 nm, intensive light was emitted from the phosphorescent compound (MC-2). From this, it was confirmed that the luminous efficiency of the mixture is high.

<Example 37>

A mixture (solution) was prepared in the same manner as in Example 25 except that the phosphorescent compound (MC-1) in Example 25 was replaced with the phosphorescent compound (MC-2). When the resultant solid film was irradiated with UV rays of 365 nm, intensive light was emitted from the phosphorescent compound (MC-2). From this, it was confirmed that the luminous efficiency of the mixture is high.

<Example 38>

A mixture (solution) was prepared in the same manner as in Example 26 except that the phosphorescent compound (MC-1) in Example 26 was replaced with the phosphorescent compound (MC-2). When the resultant solid film was irradiated with UV rays of 365 nm, intensive light was emitted from the phosphorescent compound (MC-2). From this, it was confirmed that the luminous efficiency of the mixture is high.

<Example 39>

A mixture (solution) was prepared in the same manner as in Example 29 except that the phosphorescent compound (MC-1) in Example 29 was replaced with the phosphorescent compound (MC-2). When the resultant solid film was irradiated with UV rays of 365 nm, intensive light was emitted from the phosphorescent compound (MC-2). From this, it was confirmed that the luminous efficiency of the mixture is high.

<Comparative Example 1>

A polymer compound (P-1) represented by the following formula:

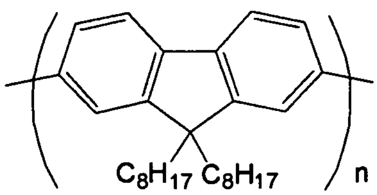

(P-1)

wherein n is the number of polymerization units,
had a lowest triplet excitation energy value $T_1$ (1/n = 0) of 2.6 eV, and an absolute value of a lowest unoccupied molecular orbital energy level ($E_{LUMO}$) (1/n = 0) of 2.1 eV, which were extrapolation values at n = ∞, and the smallest dihedral

angle of 45°.

Parameters were calculated in the same manner as in Example 1 by using a simplified repeating unit (M-3) represented by the following formula:

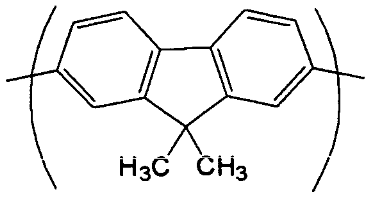

(M-1)

Subsequently, a mixture (10 μl) containing the polymer compound (P-3) and the phosphorescent compound (MC-1) was prepared, added dropwise to a slide glass and air-dried to obtain a solid film. When the solid film was irradiated with UV rays of 365 nm, weak light was emitted from the phosphorescent compound (MC-1). From this, it was confirmed that the luminous efficiency of the mixture is low.

INDUSTRIAL APPLICABILITY

The composition, etc. of the present invention can be used for preparing a light-emitting device having excellent luminous efficiency.

## Claims

1. A composition comprising: a compound having a saturated heterocyclic structure, the ring including a nitrogen atom and the constituent members of the ring being 5 or more, and a phosphorescent compound.

2. The composition according to claim 1, wherein the compound having a saturated heterocyclic structure is a compound having a residue of a compound represented by a formula selected from the group consisting of formulas (1-1), (1-2), (1-3), (2-1), (2-2), (2-3) and (2-4) given below:

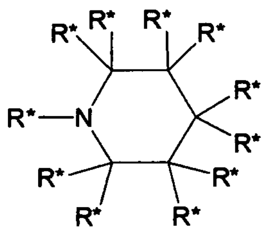

(1-1)

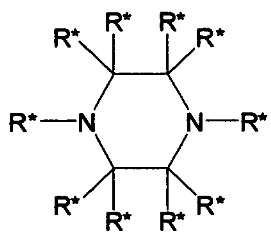

(1-2)

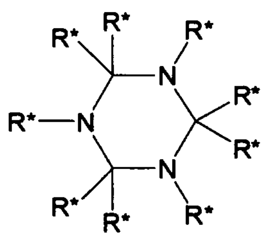

(1-3)

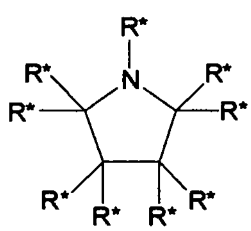

(2-1)

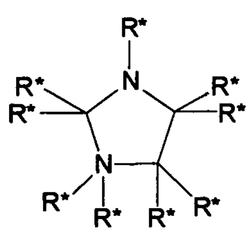

(2-2)

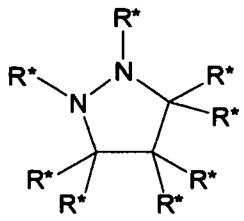

(2-3)

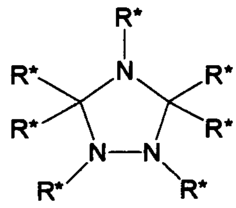

(2-4)

wherein R* each represents a hydrogen atom or a substituent or two R* bound to the same carbon atom integrally represent =0; and a plurality oft* may be the same or different.

3. The composition according to claim 2, wherein the compound having a saturated heterocyclic structure is a compound represented by formula (3) given below or a compound having a residue the foregoing compound.

$$ET^1 \left( Y^1 \right)_{m_1} \left( HT \right)_n \left( Y^2 \right)_{m_2} ET^2 \qquad (3)$$

wherein HT represents a residue of a compound represented by the above formula (1-1), (1-2), (1-3), (2-1), (2-2), (2-3) or (2-4); n is an integer of 1 to 5; when n is 2 or more, a plurality ofHT may be the same or different; $Y^1$ and $Y^2$ each independently represent -C($R^a$)($R^b$)-, -N($R^c$)-, -O-, -Si($R^d$)($R^e$)-, -P($R^f$)-, -S-, -C(=O)- or -C($R^g$)=C($R^h$)-; $R^a$, $R^b$, $R^c$, $R^d$, $R^e$, $R^f$, $R^g$ and $R^h$ each independently represent a hydrogen atom or a substituent; $m_1$ and $m_2$ are each independently an integer of 0 to 5; when $m_1$ is 2 or more, a plurality of $Y^1$ may be the same or different; when $m_2$ is 2 or more, a plurality of $Y^2$ may be the same or different; $ET^1$ and $ET^2$ each independently represent an aryl group that may have a substituent or a heteroaryl group that may have a substituent.

4. The composition according to claim 3, wherein at least one of the $ET^1$ and $ET^2$ is a heteroaryl group that may have a substituent.

5. The composition according to claim 4, wherein the heteroaryl group that may have a substituent is a heteroaryl group substituted by an alkyl group, an alkoxy group, an aryl group that may have a substituent or a heteroaryl group that may have a substituent.

6. The composition according to claim 5, wherein the heteroaryl group that may have a substituent is a heteroaryl group substituted by an alkyl group having 3 to 10 carbon atoms, an alkoxy group having 3 to 10 carbon atoms, an aryl group substituted by an alkyl group having 3 to 10 carbon atoms or an alkoxy group having 3 to 10 carbon atoms, or an alkyl group having 3 to 10 carbon atoms or an alkoxy group having 3 to 10 carbon atoms.

7. The composition according to any one of claims 1 to 6, wherein the lowest triplet excitation energy value of the compound having a saturated heterocyclic structure as calculated by a computational scientific approach is 3.0 eV or more.

8. The composition according to any one of claims 1 to 7, wherein the absolute value of a lowest unoccupied molecular orbital energy level of the compound having a saturated heterocyclic structure as calculated by a computational scientific approach is 1.5 eV or more.

9. The composition according to any one of claims 1 to 7, wherein the absolute value of a highest occupied molecular orbital energy level of the compound having a saturated heterocyclic structure as calculated by a computational scientific approach is 6.0 eV or less.

10. The composition according to any one of claims 3 to 9, wherein in a compound represented by the above formula (3) or a compound containing a residue of the foregoing compound, groups represented by $ET^1$ and $ET^2$ bind to a partial structure having at least two π-conjugated electrons, dihedral angles between the groups represented by

$ET^1$ and $ET^2$ and the partial structure are 20° or more.

**11.** The composition according to any one of claims 1 to 10, wherein the lowest triplet excitation energy value (ETP) of the compound having a saturated heterocyclic structure and the lowest triplet excitation energy value (ETT) of the phosphorescent compound satisfy the expression given below:

$$ETP > ETT\ (eV).$$

**12.** The composition according to any one of claims 2 to 11, wherein a compound having a residue of a compound represented by the above formula (1-1), (1-2), (1-3), (2-1), (2-2), (2-3) or (2-4) as a repeating unit is a polymer compound.

**13.** A polymer compound having a residue of a compound represented by a formula selected from the group consisting of formulas (1-1), (1-2), (1-3), (2-1), (2-2), (2-3) and (2-4) given below and a residue of the phosphorescent compound.

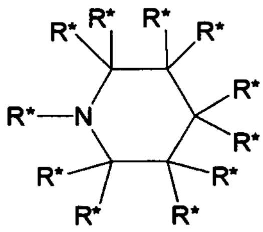

(1-1)

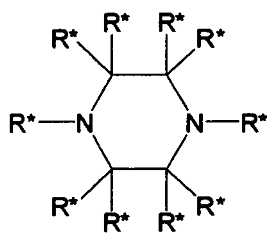

(1-2)

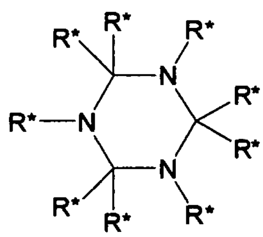

(1-3)

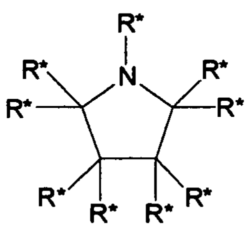

(2-1)

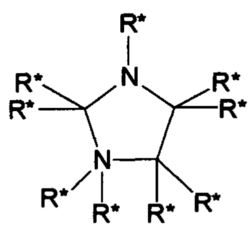

(2-2)

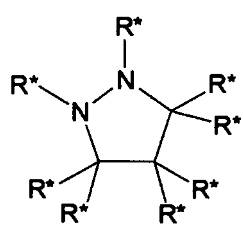

(2-3)

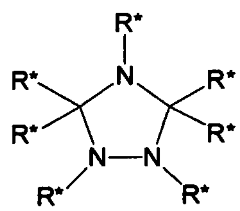

(2-4)

wherein $R^*$ each represents a hydrogen atom or a substituent or two $R^*$ bound to the same carbon atom integrally represent =O; and a plurality of $R^*$ may be the same or different.

**14.** A film prepared by using the composition according to any one of claims 1 to 12 or the polymer compound according

to claim 13.

**15.** A light-emitting device prepared by using the composition according to any one of claims 1 to 12 or the polymer compound according to claim 13.

**16.** A planar light source comprising the light-emitting device according to claim 15.

**17.** A display apparatus comprising the light-emitting device according to claim 15.

**18.** A light comprising the light-emitting device according to claim 15.

**INTERNATIONAL SEARCH REPORT**

International application No.
PCT/JP2009/061363

A. CLASSIFICATION OF SUBJECT MATTER
*H01L51/50*(2006.01)i, *C08G61/12*(2006.01)i, *C08K5/34*(2006.01)i, *C08K5/56*(2006.01)i, *C08L65/00*(2006.01)i, *C09K11/06*(2006.01)i

According to International Patent Classification (IPC) or to both national classification and IPC

B. FIELDS SEARCHED

Minimum documentation searched (classification system followed by classification symbols)
H01L51/50, C08G61/12, C08K5/34, C08K5/56, C08L65/00, C09K11/06

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)
CAplus(STN), REGISTRY(STN)

C. DOCUMENTS CONSIDERED TO BE RELEVANT

| Category* | Citation of document, with indication, where appropriate, of the relevant passages | Relevant to claim No. |
|---|---|---|
| X | JP 2008-044923 A (Toyo Ink Manufacturing Co., Ltd.),<br>28 February, 2008 (28.02.08),<br>Claims; Par. Nos. [0032] to [0034]<br>& WO 2008/010377 A1 & WO 2007/043484 A1<br>& KR 10-2008-0064114 A & CN 101282931 A | 3-6,14-18 |
| X | WO 2007/060795 A1 (Idemitsu Kosan Co., Ltd.),<br>31 May, 2007 (31.05.07),<br>Claims; Par. Nos. [0020] to [0024]<br>(Family: none) | 3-6,14-18 |
| X | JP 10-284253 A (Futaba Corp.),<br>23 October, 1998 (23.10.98),<br>Claims<br>(Family: none) | 3-6,14-18 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 11 August, 2009 (11.08.09) | 18 August, 2009 (18.08.09) |
| Name and mailing address of the ISA/<br>Japanese Patent Office<br>Facsimile No. | Authorized officer<br><br>Telephone No. |

Form PCT/ISA/210 (second sheet) (April 2007)

INTERNATIONAL SEARCH REPORT

International application No.
PCT/JP2009/061363

C (Continuation). DOCUMENTS CONSIDERED TO BE RELEVANT

| Category* | Citation of document, with indication, where appropriate, of the relevant passages | Relevant to claim No. |
|---|---|---|
| X | JP 2004-091388 A (Dainippon Printing Co., Ltd.), 25 March, 2004 (25.03.04), Claims (Family: none) | 3-6,14-18 |

Form PCT/ISA/210 (continuation of second sheet) (April 2007)

**INTERNATIONAL SEARCH REPORT**

International application No.
PCT/JP2009/061363

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☒ Claims Nos.: 1, 2, and 7 to 13.
because they relate to parts of the international application that do not comply with the prescribed requirements to such an extent that no meaningful international search can be carried out, specifically:
See extra sheet.

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:

1. ☐ As all required additional search fees were timely paid by the applicant, this international search report covers all searchable claims.
2. ☐ As all searchable claims could be searched without effort justifying additional fees, this Authority did not invite payment of additional fees.
3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest** the
☐ The additional search fees were accompanied by the applicant's protest and, where applicable, payment of a protest fee.
☐ The additional search fees were accompanied by the applicant's protest but the applicable protest fee was not paid within the time limit specified in the invitation.
☐ No protest accompanied the payment of additional search fees.

Form PCT/ISA/210 (continuation of first sheet (2)) (April 2007)

INTERNATIONAL SEARCH REPORT

International application No.
PCT/JP2009/061363

Continuation of Box No.II-2 of continuation of first sheet(2)

The inventions of claims 1 and 2 specify a "compound having a saturated heterocyclic structure" by a partial structure, and, thus, the range of compounds included in the specified compounds cannot be specified by a person skilled in the art.

The inventions of claims 7 to 11 specify the "compound having a saturated heterocyclic structure" by the results of calculation by a computational scientific method. Accordingly, the range of compounds included in the specified compounds cannot be specified by a person skilled in the art.

The inventions of claims 12 and 13 specify a polymer compound comprising a predetermined residue as a repeating unit or a composition containing the polymer compound. However, the polymer compound is not adequately supported by the description. Further, the application does not disclose the polymer compound in a manner sufficiently clear and complete for the invention to be carried out by a person skilled in the art.

(Concerning coverage of search)

The inventions of claims 3 to 6 specify compounds having residues represented by formulae (2-1) to (2-4). However, the compounds are not adequately supported by the description. Further, the application does not disclose the compounds in a manner sufficiently clear and complete for the invention to be carried out by a person skilled in the art.

Accordingly, regarding the inventions of claims 3 to 6 and 14 to 18, a search was not made for forms including the residue-containing compounds or the predetermined polymer compounds stated in claims 12 and 13.

Form PCT/ISA/210 (extra sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2002050483 A
- JP 2002241455 A
- WO 2002066552 A
- WO 2004020504 A
- WO 2004020448 A
- JP 63070257 A
- JP 63175860 A
- JP 2135359 A
- JP 2135361 A
- JP 2209988 A
- JP 3037992 A
- JP 3152184 A
- WO 0206655 A


### Non-patent literature cited in the description


- *APPLIED PHYSICS LETTERS,* 2002, vol. 80 (13), 2308
- *Nature,* 1998, vol. 395, 151
- *Appl. Phys. Lett.,* 1999, vol. 75 (1), 4
- Organic Light-Emitting Materials and DevicesIV. *Proc. SPIE-Int. Soc. Opt. Eng.,* 2001, vol. 4105, 119
- *J. Am. Chem. Soc.,* 2001, vol. 123, 4304
- *Appl. Phys. Lett.,* 1997, vol. 71 (18), 2596
- *Syn. Met.,* 1998, vol. 94 (1), 103
- *Syn. Met.,* 1999, vol. 99 (2), 1361
- *Adv. Mater.,* 1999, vol. 11 (10), 852
- *Inorg. Chem.,* 2003, vol. 42, 8609
- *Inorg. Chem.,* 2004, vol. 43, 6513
- *Journal of the SID,* 2003, vol. 11/1, 161